(19) Europäisches Patentamt
European Patent Office
Office européen des brevets

(11) **EP 4 583 412 A1**

(12) **EUROPEAN PATENT APPLICATION**
published in accordance with Art. 153(4) EPC

(43) Date of publication:
**09.07.2025 Bulletin 2025/28**

(21) Application number: **23860937.4**

(22) Date of filing: **01.09.2023**

(51) International Patent Classification (IPC):
*H03M 13/29* (2006.01)    *H03M 13/13* (2006.01)
*H03M 13/23* (2006.01)    *H03M 13/00* (2006.01)
*H04L 1/00* (2006.01)    *H04L 1/18* (2023.01)

(52) Cooperative Patent Classification (CPC):
**H03M 13/00; H03M 13/13; H03M 13/23;
H03M 13/29; H04L 1/00; H04L 1/18**

(86) International application number:
**PCT/KR2023/013047**

(87) International publication number:
**WO 2024/049262 (07.03.2024 Gazette 2024/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **01.09.2022  KR 20220110925**

(71) Applicant: **LG Electronics Inc.
Yeongdeungpo-gu
Seoul 07336 (KR)**

(72) Inventor: **KIM, Bonghoe
Seoul 06772 (KR)**

(74) Representative: **Plasseraud IP
104 Rue de Richelieu
CS92104
75080 Paris Cedex 02 (FR)**

(54) **METHOD, COMMUNICATION DEVICE, PROCESSING DEVICE, AND STORAGE MEDIUM FOR TRANSMITTING INFORMATION BLOCK, AND METHOD, COMMUNICATION DEVICE, PROCESSING DEVICE, AND STORAGE MEDIUM FOR RECEIVING INFORMATION BLOCK**

(57)    This communication device may apply convolution precoding to a bit sequence, polar-encode the convolution-precoded bit sequence, and transmit same. When the size of a polar coder for convolution precoding is 2N, pre-determined values are mapped to last m bit indexes from among first N bit indexes in a bit sequence having the length of 2N, which is an input for the convolution precoding, and bit values of an information block are mapped to K bit indexes from among remaining (2N-m) bit indexes.

**FIG. 22**

Determine first bit sequence v, which is input to convolution precoding, based on information block having length K and polar sequence $Q^{N-1}_0$ having length N — S2201

Determine second bit sequence u based on convolution precoding for first bit sequence v — S2203

Polar encoding for second bit sequence u — S2205

EP 4 583 412 A1

## Description

### TECHNICAL FIELD

The present disclosure relates to a wireless communication system.

### BACKGROUND

A variety of technologies, such as machine-to-machine (M2M) communication, machine type communication (MTC), and a variety of devices demanding high data throughput, such as smartphones and tablet personal computers (PCs), have emerged and spread. Accordingly, the volume of data throughput demanded to be processed in a cellular network has rapidly increased. In order to satisfy such rapidly increasing data throughput, carrier aggregation technology or cognitive radio technology for efficiently employing more frequency bands and multiple input multiple output (MIMO) technology or multi-base station (BS) cooperation technology for raising data capacity transmitted on limited frequency resources have been developed.

As more and more communication devices have required greater communication capacity, there has been a need for enhanced mobile broadband (eMBB) communication relative to legacy radio access technology (RAT). In addition, massive machine type communication (mMTC) for providing various services at anytime and anywhere by connecting a plurality of devices and objects to each other is one main issue to be considered in next-generation communication.

Communication system design considering services/user equipment (UEs) sensitive to reliability and latency is also under discussion. The introduction of next-generation RAT is being discussed in consideration of eMBB communication, mMTC, ultra-reliable and low-latency communication (URLLC), and the like.

### DISCLOSURE

#### Technical Problem

As new radio communication technology has been introduced, the number of UEs to which a BS should provide services in a prescribed resource region is increasing and the volume of data and control information that the BS transmits/receives to/from the UEs to which the BS provides services is also increasing. Since the amount of resources available to the BS for communication with the UE(s) is limited, a new method for the BS to efficiently receive/transmit uplink/downlink data and/or uplink/downlink control information from/to the UE(s) using the limited radio resources is needed. In other words, due to increase in the density of nodes and/or the density of UEs, a method for efficiently using high-density nodes or high-density UEs for communication is needed.

A method to efficiently support various services with different requirements in a wireless communication system is also needed.

Overcoming delay or latency is an important challenge to applications, performance of which is sensitive to delay/latency.

A method for further improving the performance of a polar code proposed as an alternative to existing channel codes is required.

The objects to be achieved with the present disclosure are not limited to what has been particularly described hereinabove and other objects not described herein will be more clearly understood by persons skilled in the art from the following detailed description.

#### Technical Solution

According to an aspect of the present disclosure, a method of transmitting an information block by a communication device in a wireless communication system is provided. The method includes determining a first bit sequence $\mathbf{v}^{2N} = \{v_0,...,v_{2N-1}\}$, which is an input to convolution precoding, based on the information block of length K and a polar sequence $\mathbf{Q}^{2N-1}_0 = \{Q_0, Q_1, ..., Q_{2N-1}\}$ of length 2N, determining a second bit sequence $\mathbf{u}^{2N} = \{u_0,...,u_{2N-1}\}$ based on performing the convolution precoding on the first bit sequence, determining a third bit sequence including bits coded based on polar encoding for the second bit sequence, and transmitting the third bit sequence to another communication device, wherein the polar sequence $\mathbf{Q}^{2N-1}_0 = \{Q_0, Q_1, ..., Q_{2N-1}\}$ of length 2N is defined in ascending order of reliability $W(Q^{2N}_0) < W(Q^{2N}_1) < ... < W(Q^{2N}_{2N-1})$, where $0 <= Q^{2N}_i <= 2N - 1$ is a bit index for $i = 0, 1, ..., 2N - 1$, and $W(Q^{2N}_i)$ is reliability of bit index $Q^{2N}_i$, and the determining of the first bit sequence $\mathbf{v}^{2N}$ includes mapping predetermined bit values to last m bit indices from among first N bit indices in the first bit sequence $\mathbf{v}^{2N}$ and mapping K bit values of the information block to K bit indices from among remaining (2N-m) bit indices, where m is a number of shift registers for the convolution precoding.

**EP 4 583 412 A1**

According to another aspect of the present disclosure, a communication device for transmitting an information block in a wireless communication system is provided. The communication device includes at least one transceiver, at least one processor, and at least one computer memory operably connected to the at least one processor and storing instructions that, when executed, cause the at least one processor to perform operations including determining a first bit sequence $\mathbf{v}^{2N} = \{v_0,....v_{2N-1}\}$, which is an input to convolution precoding, based on the information block of length K and a polar sequence $\mathbf{Q}^{2N-1}_0 = \{Q_0, Q_1, ..., Q_{2N-1}\}$ of length 2N, determining a second bit sequence $\mathbf{u}^{2N} = \{u_0,...,u_{2N-1}\}$ based on performing the convolution precoding on the first bit sequence, determining a third bit sequence including bits coded based on polar encoding for the second bit sequence, and transmitting the third bit sequence to another communication device, wherein the polar sequence $\mathbf{Q}^{2N-1}_0 = \{Q_0, Q_1, ..., Q_{2N-1}\}$ of length 2N is defined in ascending order of reliability $W(Q^{2N}_0)$ $<W(Q^{2N}_1)<...<W(Q^{2N}_{2N-1})$, where $0 <= Q^{2N}_i <= 2N - 1$ is a bit index for i = 0, 1, ..., 2N - 1, and $W(Q^{2N}_i)$ is reliability of bit index $Q^{2N}_i$, and the determining of the first bit sequence $\mathbf{v}^{2N}$ includes mapping predetermined bit values to last m bit indices from among first N bit indices in the first bit sequence $\mathbf{v}^{2N}$ and mapping K bit values of the information block to K bit indices from among remaining (2N-m) bit indices, where m is a number of shift registers for the convolution precoding.

According to another aspect of the present disclosure, a processing device is provided. The processing device includes at least one processor, and at least one computer memory operably connected to the at least one processor and storing instructions that, when executed, cause the at least one processor to perform operations including determining a first bit sequence $\mathbf{v}^{2N} = \{v_0,...,v_{2N-1}\}$, which is an input to convolution precoding, based on an information block of length K and a polar sequence $\mathbf{Q}^{2N-1}_0 = \{Q_0, Q_1, ..., Q_{2N-1}\}$ of length 2N, determining a second bit sequence $\mathbf{u}^{2N} = \{u_0,...,u_{2N-1}\}$ based on performing the convolution precoding on the first bit sequence, determining a third bit sequence including bits coded based on polar encoding for the second bit sequence, and transmitting the third bit sequence to another communication device, wherein the polar sequence $\mathbf{Q}^{2N-1}_0 = \{Q_0, Q_1, ..., Q_{2N-1}\}$ of length 2N is defined in ascending order of reliability $W(Q^{2N}_0)<W(Q^{2N}_1)<...<W(Q^{2N}_{2N-1})$, where $0 <= Q^{2N}_i <= 2N - 1$ is a bit index for i = 0, 1, ..., 2N - 1, and $W(Q^{2N}_i)$ is reliability of bit index $Q^{2N}_i$, and the determining of the first bit sequence $\mathbf{v}^{2N}$ includes mapping predetermined bit values to last m bit indices from among first N bit indices in the first bit sequence $v^{2N}$ and mapping K bit values of the information block to K bit indices from among remaining (2N-m) bit indices, where m is a number of shift registers for the convolution precoding.

According to another aspect of the present disclosure, a computer-readable storage medium is provided. The storage medium stores at least one computer program code including instructions that, when executed, cause at least one processor to perform operations and the operations include determining a first bit sequence $\mathbf{v}^{2N} = \{v_0,....v_{2N-1}\}$, which is an input to convolution precoding, based on an information block of length K and a polar sequence $\mathbf{Q}^{2N-1}_0 = \{Q_0, Q_1, ..., Q_{2N-1}\}$ of length 2N, determining a second bit sequence $\mathbf{u}^{2N} = \{u_0,...,u_{2N-1}\}$ based on performing the convolution precoding on the first bit sequence, determining a third bit sequence including bits coded based on polar encoding for the second bit sequence, and transmitting the third bit sequence to another communication device, wherein the polar sequence $\mathbf{Q}^{2N-1}_0 = \{Q_0, Q_1, ..., Q_{2N-1}\}$ of length 2N is defined in ascending order of reliability $W(Q^{2N}_0)<W(Q^{2N}_1)<...<W(Q^{2N}_{2N-1})$, where $0 <= Q^{2N}_i <= 2N - 1$ is a bit index for i = 0, 1, ..., 2N - 1, and $W(Q^{2N}_i)$ is reliability of bit index $Q^{2N}_i$, and the determining of the first bit sequence $\mathbf{v}^{2N}$ includes mapping predetermined bit values to last m bit indices from among first N bit indices in the first bit sequence $\mathbf{v}^{2N}$ and mapping K bit values of the information block to K bit indices from among remaining (2N-m) bit indices, where m is a number of shift registers for the convolution precoding.

According to another aspect of the present disclosure, a method of receiving an information block by a communication device in a wireless communication system is provided. The method includes receiving a third bit sequence including coded bits, and obtaining the information block of length K based on the third bit sequence, wherein the third bit sequence is provided based on polar encoding for a second bit sequence $\mathbf{u}^{2N} = \{u_0,...,u_{2N-1}\}$, the second bit sequence is provided via convolution precoding for a first bit sequence $\mathbf{v}^{2N} = \{v_0,....v_{2N-1}\}$, the first bit sequence $\mathbf{v}^{2N}$ is provided based on the information block of length K and a polar sequence $\mathbf{Q}^{2N-1}_0 = \{Q_0, Q_1, ..., Q_{2N-1}\}$ of length 2N, the polar sequence $\mathbf{Q}^{2N-1}_0 = \{Q_0, Q_1, ..., Q_{2N-1}\}$ of length 2N is defined in ascending order of reliability $W(Q^{2N}_0)<W(Q^{2N}_1)$ $<...<W(Q^{2N}_{2N-1})$, where $0 <= Q^{2N}_i <= 2N - 1$ is a bit index for i = 0, 1, ..., 2N - 1, and $W(Q^{2N}_i)$ is reliability of bit index $Q^{2N}_i$, and from among first N bit indices in the first bit sequence $\mathbf{v}^{2N}$, last m bit indices include predetermined bit values, and from among remaining (2N-m) bit indices, K bit indices include K bit values of the information block, where m is a number of shift registers for the convolution precoding.

According to another aspect of the present disclosure, a communication device for receiving an information block in a wireless communication system is provided. The communication device includes at least one transceiver, at least one processor, and at least one computer memory operably connected to the at least one processor and storing instructions that, when executed, cause the at least one processor to perform operations including receiving a third bit sequence including coded bits, and obtaining the information block of length K based on the third bit sequence, wherein the third bit sequence is provided based on polar encoding for a second bit sequence $\mathbf{u}^{2N} = \{u_0,...,u_{2N-1}\}$, the second bit sequence is provided via convolution precoding for a first bit sequence $\mathbf{v}^{2N} = \{v_0,...,v_{2N-1}\}$, the first bit sequence $\mathbf{v}^{2N}$ is provided based on the information block of length K and a polar sequence $\mathbf{Q}^{2N-1}_0 = \{Q_0, Q_1, ..., Q_{2N-1}\}$ of length 2N, the polar sequence $\mathbf{Q}^{2N-1}_0 = \{Q_0, Q_1, ..., Q_{2N-1}\}$ of length 2N is defined in ascending order of reliability $W(Q^{2N}_0)<W(Q^{2N}_1)<...<W(Q^{2N}_{2N-1})$,

where $0 <= Q^{2N}_i <= 2N - 1$ is a bit index for $i = 0, 1, ..., 2N - 1$, and $W(Q^{2N}_i)$ is reliability of bit index $Q^{2N}_i$, and from among first N bit indices in the first bit sequence v2N, last m bit indices include predetermined bit values, and from among remaining (2N-m) bit indices, K bit indices include K bit values of the information block, where m is a number of shift registers for the convolution precoding.

According to another aspect of the present disclosure, a processing device is provided. The processing device includes at least one processor, and at least one computer memory operably connected to the at least one processor and storing instructions that, when executed, cause the at least one processor to perform operations including receiving a third bit sequence including coded bits, and obtaining an information block of length K based on the third bit sequence, wherein the third bit sequence is provided based on polar encoding for a second bit sequence $\mathbf{u}^{2N} = \{u_0,...,u_{2N-1}\}$, the second bit sequence is provided via convolution precoding for a first bit sequence $\mathbf{v}^{2N} = \{v_0,...,v_{2N-1}\}$, the first bit sequence $\mathbf{v}^{2N}$ is provided based on the information block of length K and a polar sequence $\mathbf{Q}^{2N-1}_0 = \{Q_0, Q_1, ..., Q_{2N-1}\}$ of length 2N, the polar sequence $Q^{2N-1}_0 = \{Q_0, Q_1, ..., Q_{2N-1}\}$ of length 2N is defined in ascending order of reliability $W(Q^{2N}_0) < W(Q^{2N}_1) < ... < W(Q^{2N}_{2N-1})$, where $0 <= Q^{2N}_i <= 2N - 1$ is a bit index for $i = 0, 1, ..., 2N-1$, and $W(Q^{2N}_i)$ is reliability of bit index $Q^{2N}_i$, and from among first N bit indices in the first bit sequence $\mathbf{v}^{2N}$, last m bit indices include predetermined bit values, and from among remaining (2N-m) bit indices, K bit indices include K bit values of the information block, where m is a number of shift registers for the convolution precoding.

According to another aspect of the present disclosure, a computer-readable storage medium is provided. The storage medium stores at least one computer program code including instructions that, when executed, cause at least one processor to perform operations, the operations including receiving a third bit sequence including coded bits, and obtaining an information block having a length K based on the third bit sequence, wherein the third bit sequence is provided based on polar encoding for a second bit sequence $\mathbf{u}^{2N} = \{u_0,...,u_{2N-1}\}$, the second bit sequence is provided via convolution precoding for a first bit sequence $\mathbf{v}^{2N} = \{v_0,...,v_{2N-1}\}$, the first bit sequence $\mathbf{v}^{2N}$ is provided based on the information block of length K and a polar sequence $\mathbf{Q}^{2N-1}_0 = \{Q_0, Q_1, ..., Q_{2N-1}\}$ of length 2N, the polar sequence $\mathbf{Q}^{2N-1}_0 = \{Q_0, Q_1, ..., Q_{2N-1}\}$ of length 2N is defined in ascending order of reliability $W(Q^{2N}_0) < W(Q^{2N}_1) < ... < W(Q^{2N}_{2N-1})$, where $0 <= Q^{2N}_i <= 2N - 1$ is a bit index for $i = 0, 1, ..., 2N - 1$, and $W(Q^{2N}_i)$ is reliability of bit index $Q^{2N}_i$, and from among first N bit indices in the first bit sequence $\mathbf{v}^{2N}$, last m bit indices include predetermined bit values, and from among remaining (2N-m) bit indices, K bit indices include K bit values of the information block, where m is a number of shift registers for the convolution precoding.

In each aspect of the present disclosure, the last m bit indices may be frozen.

In each aspect of the present disclosure, the last m bit indices may include 0 in $v_j$ as the predetermined bit values.

In each aspect of the present disclosure, the second bit sequence may be provided based on the first bit sequence $\mathbf{v}^{2N} = \{v_0,...,v_{2N-1}\}$ and $u_n = v_n + \sum_{k=1}^{m} c_k u_{n-k}$, where $c_k$ is an element of an impulse response $\mathbf{c} = (c_0, ..., c_m)$, $k = 0,...,m$, $u_n$ is an element of the second bit sequence, $n = 0,...,2N-1$, and $u_0 = v_0$.

In each aspect of the present disclosure, $v_j$ from among the last m bit indices may include a bit value satisfying:

$$v'_j = \sum_{k=1}^{m} c_k u'_{j-k}$$, where $j = N-m, ..., N-1$.

In each aspect of the present disclosure, the K-bit indices from among the remaining (2N-m) bit indices may be the most reliable K-bit indices based on the polar sequence $\mathbf{Q}^{2N-1}_0 = \{Q_0, Q_1, ..., Q_{2N-1}\}$ of length 2N.

The foregoing solutions are merely a part of the examples of the present disclosure and various examples into which the technical features of the present disclosure are incorporated may be derived and understood by persons skilled in the art from the following detailed description.

**Advantageous Effects**

According to some implementation(s) of the present disclosure, a wireless communication signal may be efficiently transmitted/received. Accordingly, the total throughput of a wireless communication system may be raised.

According to some implementation(s) of the present disclosure, the performance of channel coding based on a polar code may be improved by maximizing a minimum distance between codewords.

According to some implementation(s) of the present disclosure, various information sizes may be supported in a polarization adjusted convolution (PAC) code while maximizing a minimum distance between codewords.

According to some implementation(s) of the present disclosure, an incremental redundancy (IR) HARQ may be supported for user data encoded through the PAC code.

The effects according to the present disclosure are not limited to what has been particularly described hereinabove and other effects not described herein will be more clearly understood by persons skilled in the art related to the present disclosure from the following detailed description.

## BRIEF DESCRIPTION OF THE DRAWINGS

The accompanying drawings, which are included to provide a further understanding of the present disclosure, illustrate examples of implementations of the present disclosure and together with the detailed description serve to explain implementations of the present disclosure:

FIG. 1 illustrates an example of a communication system 1 to which implementations of the present disclosure are applied;

FIG. 2 is a block diagram illustrating examples of communication devices capable of performing a method according to the present disclosure;

FIG. 3 illustrates another example of a wireless device capable of performing implementation(s) of the present disclosure;

FIG. 4 illustrates an example of a frame structure used in a 3rd generation partnership project (3GPP)-based wireless communication system;

FIG. 5 illustrates a process for processing a transport block (TB) on a transmitting side;

FIG. 6 is an exemplary block diagram for a polar encoder;

FIG. 7 illustrates the concept of channel splitting and channel combining for channel polarization;

FIG. 8 illustrates N-th level channel combining for polar codes;

FIG. 9 illustrates evolution of decoding paths in a list-L decoding process;

FIG. 10 is a diagram to explain the concept of selecting position(s) to which information bit(s) are to be allocated in polar codes;

FIG. 11 illustrates puncturing and information bit allocation for polar codes;

FIG. 12 illustrates a method of generating parity check bit(s) used in polar codes;

FIG. 13 is a diagram to explain a rate matching process according to some implementations of the present disclosure;

FIG. 14 illustrates a structure of one of encoders/decoders for a PAC code available for some implementations of the present disclosure;

FIG. 15 illustrates a codeword tree for explaining a concept of sequential decoding;

FIG. 16 illustrates examples of allocating information bits to a polar encoder according to some implementations of the present disclosure;

FIGS. 17 and 18 illustrate input sequences to convolution according to some implementations of the present disclosure;

FIGS. 19 and 20 illustrate recursive convolution operations;

FIG. 21 illustrates an input sequence to convolution according to some implementations of the present disclosure;

FIG. 22 illustrates a channel encoding process according to some implementations of the present disclosure; and

FIG. 23 illustrates a channel decoding process according to some implementations of the present disclosure.

## DETAILED DESCRIPTION

Hereinafter, implementations according to the present disclosure will be described in detail with reference to the accompanying drawings. The detailed description, which will be given below with reference to the accompanying drawings, is intended to explain exemplary implementations of the present disclosure, rather than to show the only implementations that may be implemented according to the present disclosure. The following detailed description includes specific details in order to provide a thorough understanding of the present disclosure. However, it will be apparent to those skilled in the art that the present disclosure may be practiced without such specific details.

In some instances, known structures and devices may be omitted or may be shown in block diagram form, focusing on important features of the structures and devices, so as not to obscure the concept of the present disclosure. The same reference numbers will be used throughout the present disclosure to refer to the same or like parts.

A technique, a device, and a system described below may be applied to a variety of wireless multiple access systems. The multiple access systems may include, for example, a code division multiple access (CDMA) system, a frequency division multiple access (FDMA) system, a time division multiple access (TDMA) system, an orthogonal frequency division multiple access (OFDMA) system, a single-carrier frequency division multiple access (SC-FDMA) system, a multi-carrier frequency division multiple access (MC-FDMA) system, etc. CDMA may be implemented by radio technology such as universal terrestrial radio access (UTRA) or CDMA2000. TDMA may be implemented by radio technology such as global system for mobile communications (GSM), general packet radio service (GPRS), enhanced data rates for GSM evolution (EDGE) (i.e., GERAN), etc. OFDMA may be implemented by radio technology such as institute of electrical and electronics engineers (IEEE) 802.11 (Wi-Fi), IEEE 802.16 (WiMAX), IEEE 802.20, evolved-UTRA (E-UTRA), etc. UTRA is part of universal mobile telecommunications system (UMTS) and 3rd generation partnership project (3GPP) long-term evolution (LTE) is part of E-UMTS using E-UTRA. 3GPP LTE adopts OFDMA on downlink (DL) and adopts SC-FDMA on uplink (UL). LTE-advanced (LTE-A) is an evolved version of 3GPP LTE.

For convenience of description, description will be given under the assumption that the present disclosure is applied to LTE and/or new RAT (NR). However, the technical features of the present disclosure are not limited thereto. For example, although the following detailed description is given based on mobile communication systems corresponding to 3GPP LTE/NR systems, the mobile communication systems are applicable to other arbitrary mobile communication systems except for matters that are specific to the 3GPP LTE/NR system.

For terms and techniques that are not described in detail among terms and techniques used in the present disclosure, reference may be made to 3GPP based standard specifications, for example, 3GPP TS 36.211, 3GPP TS 36.212, 3GPP TS 36.213, 3GPP TS 36.321, 3GPP TS 36.300, 3GPP TS 36.331, 3GPP TS 37.213, 3GPP TS 38.211, 3GPP TS 38.212, 3GPP TS 38.213, 3GPP TS 38.214, 3GPP TS 38.300, 3GPP TS 38.331, etc.

In examples of the present disclosure described later, if a device "assumes" something, this may mean that a channel transmission entity transmits a channel in compliance with the corresponding "assumption" This also may mean that a channel reception entity receives or decodes the channel in the form of conforming to the "assumption" on the premise that the channel has been transmitted in compliance with the "assumption"

In the present disclosure, a user equipment (UE) may be fixed or mobile. Each of various devices that transmit and/or receive user data and/or control information by communicating with a base station (BS) may be the UE. The term UE may be referred to as terminal equipment, mobile station (MS), mobile terminal (MT), user terminal (UT), subscriber station (SS), wireless device, personal digital assistant (PDA), wireless modem, handheld device, etc. In the present disclosure, a BS refers to a fixed station that communicates with a UE and/or another BS and exchanges data and control information with a UE and another BS. The term BS may be referred to as advanced base station (ABS), Node-B (NB), evolved Node-B (eNB), base transceiver system (BTS), access point (AP), processing server (PS), etc. Particularly, a BS of a universal terrestrial radio access (UTRAN) is referred to as an NB, a BS of an evolved-UTRAN (E-UTRAN) is referred to as an eNB, and a BS of new radio access technology network is referred to as a gNB. Hereinbelow, for convenience of description, the NB, eNB, or gNB will be referred to as a BS regardless of the type or version of communication technology.

In the present disclosure, a node refers to a fixed point capable of transmitting/receiving a radio signal to/from a UE by communication with the UE. Various types of BSs may be used as nodes regardless of the names thereof. For example, a BS, NB, eNB, pico-cell eNB (PeNB), home eNB (HeNB), relay, repeater, etc. may be a node. Furthermore, a node may not be a BS. For example, a radio remote head (RRH) or a radio remote unit (RRU) may be a node. Generally, the RRH and RRU have power levels lower than that of the BS. Since the RRH or RRU (hereinafter, RRH/RRU) is connected to the BS through a dedicated line such as an optical cable in general, cooperative communication according to the RRH/RRU and the BS may be smoothly performed relative to cooperative communication according to BSs connected through a wireless link. At least one antenna is installed per node. An antenna may refer to a physical antenna port or refer to a virtual antenna or an antenna group. The node may also be called a point.

In the present disclosure, a cell refers to a specific geographical area in which one or more nodes provide communication services. Accordingly, in the present disclosure, communication with a specific cell may mean communication with a BS or a node providing communication services to the specific cell. A DL/UL signal of the specific cell refers to a DL/UL signal from/to the BS or the node providing communication services to the specific cell. A cell providing UL/DL communication services to a UE is especially called a serving cell. Furthermore, channel status/quality of the specific cell refers to channel status/quality of a channel or a communication link generated between the BS or the node providing communication services to the specific cell and the UE. In 3GPP-based communication systems, the UE may measure a DL channel state from a specific node using cell-specific reference signal(s) (CRS(s)) transmitted on a CRS resource and/or channel state information reference signal(s) (CSI-RS(s)) transmitted on a CSI-RS resource, allocated to the specific node by antenna port(s) of the specific node.

A 3GPP-based communication system uses the concept of a cell in order to manage radio resources, and a cell related with the radio resources is distinguished from a cell of a geographic area.

The "cell" of the geographic area may be understood as coverage within which a node may provide services using a carrier, and the "cell" of the radio resources is associated with bandwidth (BW), which is a frequency range configured by the carrier. Since DL coverage, which is a range within which the node is capable of transmitting a valid signal, and UL coverage, which is a range within which the node is capable of receiving the valid signal from the UE, depend upon a carrier carrying the signal, coverage of the node may also be associated with coverage of the "cell" of radio resources used by the node. Accordingly, the term "cell" may be used to indicate service coverage by the node sometimes, radio resources at other times, or a range that a signal using the radio resources may reach with valid strength at other times.

In 3GPP communication standards, the concept of the cell is used in order to manage radio resources. The "cell" associated with the radio resources is defined by a combination of DL resources and UL resources, that is, a combination of a DL component carrier (CC) and a UL CC. The cell may be configured by the DL resources only or by the combination of the DL resources and the UL resources. If carrier aggregation is supported, linkage between a carrier frequency of the DL resources (or DL CC) and a carrier frequency of the UL resources (or UL CC) may be indicated by system information. For example, the combination of the DL resources and the UL resources may be indicated by system information block type 2 (SIB2) linkage. In this case, the carrier frequency may be equal to or different from a center frequency of each cell or CC. When carrier aggregation (CA) is configured, the UE has only one radio resource control (RRC) connection with a network. During RRC connection establishment/re-establishment/handover, one serving cell provides non-access stratum (NAS) mobility information. During RRC connection re-establishment/handover, one serving cell provides security input. This cell is referred to as a primary cell (Pcell). The Pcell refers to a cell operating on a primary frequency on which the UE performs an initial connection establishment procedure or initiates a connection re-establishment procedure. According to UE capability, secondary cells (Scells) may be configured to form a set of serving cells together with the Pcell. The Scell may be configured after completion of RRC connection establishment and used to provide additional radio resources in addition to resources of a specific cell (SpCell). A carrier corresponding to the Pcell on DL is referred to as a downlink primary CC (DL PCC), and a carrier corresponding to the Pcell on UL is referred to as an uplink primary CC (UL PCC). A carrier corresponding to the Scell on DL is referred to as a downlink secondary CC (DL SCC), and a carrier corresponding to the Scell on UL is referred to as an uplink secondary CC (UL SCC).

In a dual connectivity (DC) operation, the term special cell (SpCell) refers to a Pcell of a master cell group (MCG) or a primary secondary cell (PSCell) of a secondary cell group (SCG). The SpCell supports PUCCH transmission and contention-based random access and is always activated. The MCG is a group of service cells associated with a master node (e.g., BS) and includes the SpCell (Pcell) and optionally one or more Scells. For a UE configured with DC, the SCG is a subset of serving cells associated with a secondary node and includes the PSCell and 0 or more Scells. The PSCell is a primary Scell of the SCG. For a UE in RRC_CONNECTED state, that is not configured with CA or DC, only one serving cell including only the Pcell is present. For a UE in RRC_CONNECTED state, that is configured with CA or DC, the term serving cells refers to a set of cells including SpCell(s) and all Scell(s). In DC, two medium access control (MAC) entities, i.e., one MAC entity for the MCG and one MAC entity for the SCG, are configured for the UE.

For a UE that is configured with CA and is not configured with DC, a Pcell PUCCH group including the Pcell and 0 or more Scells and an Scell PUCCH group including only Scell(s) may be configured. For the Scell, an Scell on which a PUCCH associated with the corresponding cell is transmitted (hereinafter, a PUCCH cell) may be configured. An Scell for which a PUCCH Scell is indicated belongs to the Scell PUCCH group and PUCCH transmission of related uplink control information (UCI) is performed on the PUCCH Scell. If a PUCCH Scell is not indicated for an Scell or a cell which is indicated for PUCCH transmission for the Scell is a Pcell, the Scell belongs to the Pcell PUCCH group and PUCCH transmission of related UCI is performed on the Pcell.

In a wireless communication system, the UE receives information on DL from the BS and the UE transmits information on UL to the BS. The information that the BS and UE transmit and/or receive includes data and a variety of control information and there are various physical channels according to types/usage of the information that the UE and the BS transmit and/or receive.

The 3GPP-based communication standards define DL physical channels corresponding to resource elements carrying information originating from a higher layer and DL physical signals corresponding to resource elements which are used by the physical layer but do not carry the information originating from the higher layer. For example, a physical downlink shared channel (PDSCH), a physical broadcast channel (PBCH), a physical multicast channel (PMCH), a physical control format indicator channel (PCFICH), a physical downlink control channel (PDCCH), etc. are defined as the DL physical channels, and a reference signal (RS) and a synchronization signal (SS) are defined as the DL physical signals. The RS, which is also referred to as a pilot, represents a signal with a predefined special waveform known to both the BS and the UE. For example, a demodulation reference signal (DMRS), a channel state information RS (CSI-RS), etc. are defined as DL RSs. The 3GPP-based communication standards define UL physical channels corresponding to resource elements carrying information originating from the higher layer and UL physical signals corresponding to resource elements which are used by the physical layer but do not carry the information originating from the higher layer. For example, a physical uplink shared channel (PUSCH), a physical uplink control channel (PUCCH), and a physical random access channel (PRACH) are defined as the UL physical channels, and a DMRS for a UL control/data signal, a sounding reference signal (SRS) used for UL channel measurement, etc. are defined.

In the present disclosure, a PDCCH refers to a set of time-frequency resources (e.g., resource elements (REs)) carrying downlink control information (DCI), and a PDSCH refers to a set of time-frequency resources carrying DL data. A PUCCH, a PUSCH, and a PRACH refer to a set of time-frequency resources carrying UCI, a set of time-frequency resources carrying UL data, and a set of time-frequency resources carrying random access signals, respectively. In the following description, "the UE transmits/receives a PUCCH/PUSCH/PRACH" is used as the same meaning that the UE transmits/receives the UCI/UL data/random access signals on or through the PUCCH/PUSCH/PRACH, respectively. In addition, "the BS transmits/receives a PBCH/PDCCH/PDSCH" is used as the same meaning that the BS transmits the broadcast information/DCI/DL data on or through a PBCH/PDCCH/PDSCH, respectively.

In the present disclosure, a radio resource (e.g., a time-frequency resource) scheduled or configured to the UE by the BS for transmission or reception of the PUCCH/PUSCH/PDSCH may be referred to as a PUCCH/PUSCH/PDSCH resource.

Since a communication device receives a synchronization signal block (SSB), DMRS, CSI-RS, PBCH, PDCCH, PDSCH, PUSCH, and/or PUCCH in the form of radio signals on a cell, the communication device may not select and receive radio signals including only a specific physical channel or a specific physical signal through a radio frequency (RF) receiver, or may not select and receive radio signals without a specific physical channel or a specific physical signal through the RF receiver. In actual operations, the communication device receives radio signals on the cell via the RF receiver, converts the radio signals, which are RF band signals, into baseband signals, and then decodes physical signals and/or physical channels in the baseband signals using one or more processors. Thus, in some implementations of the present disclosure, reception of physical signals and/or physical channels may mean that a communication device does not attempt to restore the physical signals and/or physical channels from radio signals, for example, does not attempt to decode the physical signals and/or physical channels, rather than that the communication device does not actually receive the radio signals including the corresponding physical signals and/or physical channels.

As more and more communication devices have required greater communication capacity, there has been a need for eMBB communication relative to legacy radio access technology (RAT). In addition, massive MTC for providing various services at anytime and anywhere by connecting a plurality of devices and objects to each other is one main issue to be considered in next-generation communication. Further, communication system design considering services/UEs sensitive to reliability and latency is also under discussion. The introduction of next-generation RAT is being discussed in consideration of eMBB communication, massive MTC, ultra-reliable and low-latency communication (URLLC), and the like. Currently, in 3GPP, a study on the next-generation mobile communication systems after EPC is being conducted. In the present disclosure, for convenience, the corresponding technology is referred to as a new RAT (NR) or fifth-generation (5G) RAT, and a system using NR or supporting NR is referred to as an NR system.

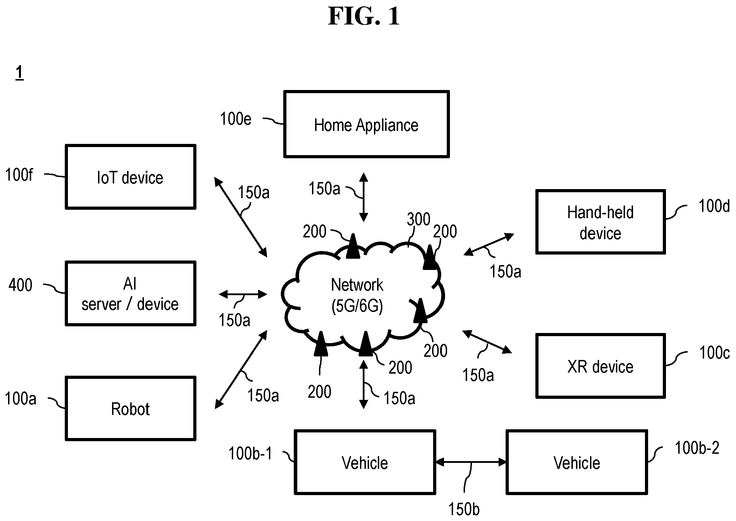

FIG. 1 illustrates an example of a communication system 1 to which implementations of the present disclosure are applied. Referring to FIG. 1, the communication system 1 applied to the present disclosure includes wireless devices, BSs, and a network. Here, the wireless devices represent devices performing communication using RAT (e.g., 5G NR or LTE (e.g., E-UTRA)) and may be referred to as communication/radio/5G devices. The wireless devices may include, without being limited to, a robot 100a, vehicles 100b-1 and 100b-2, an extended reality (XR) device 100c, a hand-held device 100d, a home appliance 100e, an Internet of Things (IoT) device 100f, and an artificial intelligence (AI) device/server 400. For example, the vehicles may include a vehicle having a wireless communication function, an autonomous driving vehicle, and a vehicle capable of performing vehicle-to-vehicle communication. Here, the vehicles may include an unmanned aerial vehicle (UAV) (e.g., a drone). The XR device may include an augmented reality (AR)/virtual reality (VR)/mixed reality (MR) device and may be implemented in the form of a head-mounted device (HMD), a head-up display (HUD) mounted in a vehicle, a television, a smartphone, a computer, a wearable device, a home appliance device, a digital signage, a vehicle, a robot, etc. The hand-held device may include a smartphone, a smartpad, a wearable device (e.g., a smartwatch or smartglasses), and a computer (e.g., a notebook). The home appliance may include a TV, a refrigerator, and a washing machine. The IoT device may include a sensor and a smartmeter. For example, the BSs and the network may also be implemented as wireless devices and a specific wireless device may operate as a BS/network node with respect to another wireless device.

The wireless devices 100a to 100f may be connected to a network 300 via BSs 200. AI technology may be applied to the wireless devices 100a to 100f and the wireless devices 100a to 100f may be connected to the AI server 400 via the network 300. The network 300 may be configured using a 3G network, a 4G (e.g., LTE) network, or a 5G (e.g., NR) network. Although the wireless devices 100a to 100f may communicate with each other through the BSs 200/network 300, the wireless devices 100a to 100f may perform direct communication (e.g., sidelink communication) with each other without passing through the BSs/network. For example, the vehicles 100b-1 and 100b-2 may perform direct communication (e.g., vehicle-to-vehicle (V2V)/Vehicle-to-everything (V2X) communication). The IoT device (e.g., a sensor) may perform direct communication with other IoT devices (e.g., sensors) or other wireless devices 100a to 100f.

Wireless communication/connections 150a and 150b may be established between the wireless devices 100a to 100f and the BSs 200 and between the wireless devices 100a to 100f). Here, the wireless communication/connections such as UL/DL communication 150a and sidelink communication 150b (or, device-to-device (D2D) communication) may be established by various RATs (e.g., 5G NR). The wireless devices and the BSs/wireless devices may transmit/receive radio signals to/from each other through the wireless communication/connections 150a and 150b. To this end, at least a part of various configuration information configuring processes, various signal processing processes (e.g., channel encoding/decoding, modulation/demodulation, and resource mapping/demapping), and resource allocating processes, for transmitting/receiving radio signals, may be performed based on the various proposals of the present disclosure.

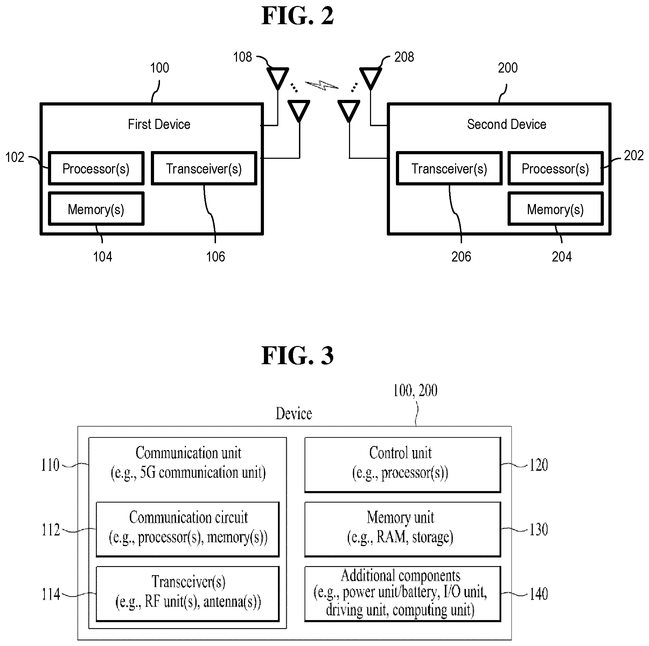

FIG. 2 is a block diagram illustrating examples of communication devices capable of performing a method according to the present disclosure. Referring to FIG. 2, a first wireless device 100 and a second wireless device 200 may transmit and/or receive radio signals through a variety of RATs (e.g., LTE and NR). Here, {the first wireless device 100 and the second wireless device 200} may correspond to {the wireless device 100x and the BS 200} and/or {the wireless device 100x and the wireless device 100x} of FIG. 1.

The first wireless device 100 may include one or more processors 102 and one or more memories 104 and additionally further include one or more transceivers 106 and/or one or more antennas 108. The processor(s) 102 may control the memory(s) 104 and/or the transceiver(s) 106 and may be configured to implement the below-described /proposed functions, procedures, and/or methods. For example, the processor(s) 102 may process information within the memory(s) 104 to generate first information/signals and then transmit radio signals including the first information/signals through the transceiver(s) 106. The processor(s) 102 may receive radio signals including second information/signals through the transceiver(s) 106 and then store information obtained by processing the second information/signals in the memory(s) 104. The memory(s) 104 may be connected to the processor(s) 102 and may store a variety of information related to operations of the processor(s) 102. For example, the memory(s) 104 may perform a part or all of processes controlled by the processor(s) 102 or store software code including instructions for performing the below-described/- proposed procedures and/or methods. Here, the processor(s) 102 and the memory(s) 104 may be a part of a communication modem/circuit/chip designed to implement RAT (e.g., LTE or NR). The transceiver(s) 106 may be connected to the processor(s) 102 and transmit and/or receive radio signals through one or more antennas 108. Each of the transceiver(s) 106 may include a transmitter and/or a receiver. The transceiver(s) 106 is used interchangeably with radio frequency (RF) unit(s). In the present disclosure, the wireless device may represent the communication modem/circuit/chip.

The second wireless device 200 may include one or more processors 202 and one or more memories 204 and additionally further include one or more transceivers 206 and/or one or more antennas 208. The processor(s) 202 may control the memory(s) 204 and/or the transceiver(s) 206 and may be configured to implement the below-described/proposed functions, procedures, and/or methods. For example, the processor(s) 202 may process information within the memory(s) 204 to generate third information/signals and then transmit radio signals including the third information/signals through the transceiver(s) 206. The processor(s) 202 may receive radio signals including fourth information/signals through the transceiver(s) 106 and then store information obtained by processing the fourth information/signals in the memory(s) 204. The memory(s) 204 may be connected to the processor(s) 202 and may store a variety of information related to operations of the processor(s) 202. For example, the memory(s) 204 may perform a part or all of processes controlled by the processor(s) 202 or store software code including instructions for performing the below-described/- proposed procedures and/or methods. Here, the processor(s) 202 and the memory(s) 204 may be a part of a communication modem/circuit/chip designed to implement RAT (e.g., LTE or NR). The transceiver(s) 206 may be connected to the processor(s) 202 and transmit and/or receive radio signals through one or more antennas 208. Each of the transceiver(s) 206 may include a transmitter and/or a receiver. The transceiver(s) 206 is used interchangeably with RF unit(s). In the present disclosure, the wireless device may represent the communication modem/circuit/chip.

The wireless communication technology implemented in the wireless devices 100 and 200 of the present disclosure may include narrowband Internet of things for low-power communication as well as LTE, NR, and 6G. For example, the NB-IoT technology may be an example of low-power wide-area network (LPWAN) technologies and implemented in standards such as LTE Cat NB1 and/or LTE Cat NB2. However, the NB-IoT technology is not limited to the above names. Additionally or alternatively, the wireless communication technology implemented in the wireless devices XXX and YYY of the present disclosure may perform communication based on the LTE-M technology. For example, the LTE-M technology may be an example of LPWAN technologies and called by various names including enhanced machine type communication (eMTC). For example, the LTE-M technology may be implemented in at least one of the following various standards: 1) LTE CAT 0, 2) LTE Cat M1, 3) LTE Cat M2, 4) LTE non-Bandwidth Limited (non-BL), 5) LTE-MTC, 6) LTE Machine Type Communication, and/or 7) LTE M, etc., but the LTE-M technology is not limited to the above names. Additionally or alternatively, the wireless communication technology implemented in the wireless devices XXX and YYY of the present disclosure may include at least one of ZigBee, Bluetooth, and LPWAN in consideration of low-power communication, but the wireless communication technology is not limited to the above names. For example, the ZigBee technology may create a personal area network (PAN) related to small/low-power digital communication based on various standards such as IEEE 802.15.4 and so on, and the ZigBee technology may be called by various names.

Hereinafter, hardware elements of the wireless devices 100 and 200 will be described more specifically. One or more protocol layers may be implemented by, without being limited to, one or more processors 102 and 202. For example, the one or more processors 102 and 202 may implement one or more layers (e.g., functional layers such as a physical (PHY) layer, medium access control (MAC) layer, a radio link control (RLC) layer, a packet data convergence protocol (PDCP) layer, radio resource control (RRC) layer, and a service data adaptation protocol (SDAP) layer). The one or more processors 102 and 202 may generate one or more protocol data units (PDUs) and/or one or more service data units (SDUs) according to the functions, procedures, proposals, and/or methods disclosed in the present disclosure. The one or more processors 102 and 202 may generate messages, control information, data, or information according to the functions, procedures, proposals, and/or methods disclosed in the present disclosure. The one or more processors 102 and 202 may generate signals (e.g., baseband signals) including PDUs, SDUs, messages, control information, data, or information according to the functions, procedures, proposals, and/or methods disclosed in the present disclosure and provide the generated signals to the one or more transceivers 106 and 206. The one or more processors 102 and 202 may receive the signals (e.g., baseband signals) from the one or more transceivers 106 and 206 and acquire the PDUs, SDUs, messages, control information, data, or information according to the functions, procedures, proposals, and/or methods disclosed in the present disclosure.

The one or more processors 102 and 202 may be referred to as controllers, microcontrollers, microprocessors, or microcomputers. The one or more processors 102 and 202 may be implemented by hardware, firmware, software, or a combination thereof. As an example, one or more application specific integrated circuits (ASICs), one or more digital signal processors (DSPs), one or more digital signal processing devices (DSPDs), one or more programmable logic devices (PLDs), or one or more field programmable gate arrays (FPGAs) may be included in the one or more processors 102 and 202. The functions, procedures, proposals, and/or methods disclosed in the present disclosure may be implemented using firmware or software, and the firmware or software may be configured to include the modules, procedures, or functions. Firmware or software configured to perform the functions, procedures, proposals, and/or methods disclosed in the present disclosure may be included in the one or more processors 102 and 202 or stored in the one or more memories 104 and 204 so as to be driven by the one or more processors 102 and 202. The functions, procedures, proposals, and/or methods disclosed in the present disclosure may be implemented using firmware or software in the form of code, commands, and/or a set of commands.

The one or more memories 104 and 204 may be connected to the one or more processors 102 and 202 and store various types of data, signals, messages, information, programs, code, commands, and/or instructions. The one or more memories 104 and 204 may be configured by read-only memories (ROMs), random access memories (RAMs), electrically erasable programmable read-only memories (EPROMs), flash memories, hard drives, registers, cash memories, computer-readable storage media, and/or combinations thereof. The one or more memories 104 and 204 may be located at the interior and/or exterior of the one or more processors 102 and 202. The one or more memories 104 and 204 may be connected to the one or more processors 102 and 202 through various technologies such as wired or wireless connection.

The one or more transceivers 106 and 206 may transmit user data, control information, and/or radio signals/channels, mentioned in the methods and/or operational flowcharts of the present disclosure, to one or more other devices. The one or more transceivers 106 and 206 may receive user data, control information, and/or radio signals/channels, mentioned in the functions, procedures, proposals, methods, and/or operational flowcharts disclosed in the present disclosure, from one or more other devices. For example, the one or more transceivers 106 and 206 may be connected to the one or more processors 102 and 202 and transmit and receive radio signals. For example, the one or more processors 102 and 202 may perform control so that the one or more transceivers 106 and 206 may transmit user data, control information, or radio signals to one or more other devices. The one or more processors 102 and 202 may perform control so that the one or more transceivers 106 and 206 may receive user data, control information, or radio signals from one or more other devices. The one or more transceivers 106 and 206 may be connected to the one or more antennas 108 and 208. The one or more transceivers 106 and 206 may be configured to transmit and receive user data, control information, and/or radio signals/channels, mentioned in the functions, procedures, proposals, methods, and/or operational flowcharts disclosed in the present disclosure, through the one or more antennas 108 and 208. In the present disclosure, the one or more antennas may be a plurality of physical antennas or a plurality of logical antennas (e.g., antenna ports). The one or more transceivers 106 and 206 may convert received radio signals/channels etc. from RF band signals into baseband signals in order to process received user data, control information, radio signals/channels, etc. using the one or more processors 102 and 202. The one or more transceivers 106 and 206 may convert the user data, control information, radio signals/channels, etc. processed using the one or more processors 102 and 202 from the base band signals into the RF band signals. To this end, the one or more transceivers 106 and 206 may include (analog) oscillators and/or filters.

FIG. 3 illustrates another example of a wireless device capable of performing implementation(s) of the present disclosure. Referring to FIG. 3, wireless devices 100 and 200 may correspond to the wireless devices 100 and 200 of FIG. 2 and may be configured by various elements, components, units/portions, and/or modules. For example, each of the wireless devices 100 and 200 may include a communication unit 110, a control unit 120, a memory unit 130, and additional components 140. The communication unit may include a communication circuit 112 and transceiver(s) 114. For example, the communication circuit 112 may include the one or more processors 102 and 202 and/or the one or more memories 104 and 204 of FIG. 2. For example, the transceiver(s) 114 may include the one or more transceivers 106 and 206 and/or the one or more antennas 108 and 208 of FIG. 2. The control unit 120 is electrically connected to the communication unit 110, the memory 130, and the additional components 140 and controls overall operation of the wireless devices. For example, the control unit 120 may control an electric/mechanical operation of the wireless device based on programs/code/commands/information stored in the memory unit 130. The control unit 120 may transmit the information stored in the memory unit 130 to the exterior (e.g., other communication devices) via the communication unit 110 through a wireless/wired interface or store, in the memory unit 130, information received through the wireless/wired interface from the exterior (e.g., other communication devices) via the communication unit 110.

The additional components 140 may be variously configured according to types of wireless devices. For example, the additional components 140 may include at least one of a power unit/battery, input/output (I/O) unit, a driving unit, and a computing unit. The wireless device may be implemented in the form of, without being limited to, the robot (100a of FIG. 1), the vehicles (100b-1 and 100b-2 of FIG. 1), the XR device (100c of FIG. 1), the hand-held device (100d of FIG. 1), the home appliance (100e of FIG. 1), the IoT device (100f of FIG. 1), a digital broadcast UE, a hologram device, a public safety device, an MTC device, a medicine device, a fintech device (or a finance device), a security device, a climate/environment device, the AI server/device (400 of FIG. 1), the BS (200 of FIG. 1), a network node, etc. The wireless device may be used in a mobile or fixed place according to a use-case/service.

In FIG. 3, the entirety of the various elements, components, units/portions, and/or modules in the wireless devices 100 and 200 may be connected to each other through a wired interface or at least a part thereof may be wirelessly connected through the communication unit 110. For example, in each of the wireless devices 100 and 200, the control unit 120 and the communication unit 110 may be connected by wire and the control unit 120 and first units (e.g., 130 and 140) may be wirelessly connected through the communication unit 110. Each element, component, unit/portion, and/or module within the wireless devices 100 and 200 may further include one or more elements. For example, the control unit 120 may be configured by a set of one or more processors. As an example, the control unit 120 may be configured by a set of a communication control processor, an application processor, an electronic control unit (ECU), a graphical processing unit, and a memory control processor. As another example, the memory 130 may be configured by a random access memory (RAM), a dynamic RAM (DRAM), a read-only memory (ROM)), a flash memory, a transitory memory, a non-transitory memory, and/or a combination thereof.

In the present disclosure, the at least one memory (e.g., 104 or 204) may store instructions or programs, and the instructions or programs may cause, when executed, at least one processor operably connected to the at least one memory to perform operations according to some embodiments or implementations of the present disclosure.

In the present disclosure, a computer readable (non-transitory) storage medium may store at least one instruction or program, and the at least one instruction or program may cause, when executed by at least one processor, the at least one processor to perform operations according to some embodiments or implementations of the present disclosure.

In the present disclosure, a processing device or apparatus may include at least one processor, and at least one computer memory operably connected to the at least one processor. The at least one computer memory may store instructions or programs, and the instructions or programs may cause, when executed, the at least one processor operably connected to the at least one memory to perform operations according to some embodiments or implementations of the present disclosure.

In the present disclosure, a computer program may include program code stored on at least one computer-readable (non-transitory) storage medium and, when executed, configured to perform operations according to some implementations of the present disclosure or cause at least one processor to perform the operations according to some implementations of the present disclosure. The computer program may be provided in the form of a computer program product. The computer program product may include at least one computer-readable (non-transitory) storage medium.

A communication device of the present disclosure includes at least one processor; and at least one computer memory operably connected to the at least one processor and configured to store instructions for causing, when executed, the at least one processor to perform operations according to example(s) of the present disclosure described later.

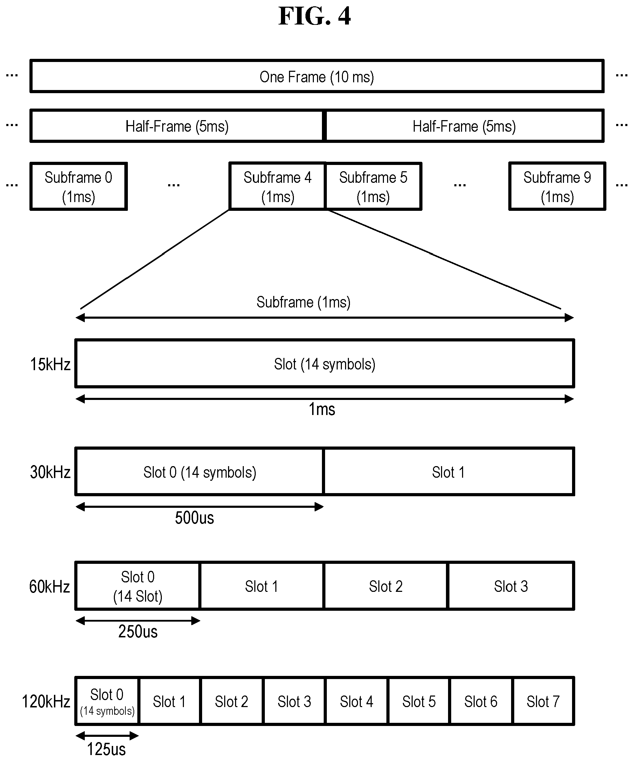

FIG. 4 illustrates an example of a frame structure used in a 3GPP-based wireless communication system.

The frame structure of FIG. 4 is purely exemplary and the number of subframes, the number of slots, and the number of symbols, in a frame, may be variously changed. In an NR system, different OFDM numerologies (e.g., subcarrier spacings (SCSs)) may be configured for multiple cells which are aggregated for one UE. Accordingly, the (absolute time) duration of a time resource including the same number of symbols (e.g., a subframe, a slot, or a transmission time interval (TTI)) may be differently configured for the aggregated cells. Here, the symbol may include an OFDM symbol (or cyclic prefix - OFDM (CP-OFDM) symbol) and an SC-FDMA symbol (or discrete Fourier transform-spread-OFDM (DFT-s-OFDM) symbol). In the present disclosure, the symbol, the OFDM-based symbol, the OFDM symbol, the CP-OFDM symbol, and the DFT-s-OFDM symbol are used interchangeably.

Referring to FIG. 4, in the NR system, UL and DL transmissions are organized into frames. Each frame has a duration of $T_f = (\triangle f_{max} * N_f / 100) * T_c = 10$ ms and is divided into two half-frames of 5 ms each. A basic time unit for NR is $T_c = 1/(\triangle f_{max} * N_f)$ where $\triangle f_{max} = 480 * 10^3$ Hz and $N_f = 4096$. For reference, a basic time unit for LTE is $T_s = 1/(\triangle f_{ref} * N_{f,ref})$ where $\triangle f_{ref} = 15 * 10^3$ Hz and $N_{f,ref} = 2048$. $T_c$ and $T_f$ have the relationship of a constant $\kappa = T_c / T_f = 64$. Each half-frame includes 5 subframes and a duration $T_{sf}$ of a single subframe is 1 ms. Subframes are further divided into slots and the number of slots in a subframe depends on a subcarrier spacing. Each slot includes 14 or 12 OFDM symbols based on a cyclic prefix. In a normal CP, each slot includes 14 OFDM symbols and, in an extended CP, each slot includes 12 OFDM symbols. The numerology depends on an exponentially scalable subcarrier spacing $\triangle f = 2^u * 15$ kHz. The table below shows the number of OFDM symbols ($N^{slot}_{symb}$) per slot, the number of slots ($N^{frame,u}_{slot}$) per frame, and the number of slots ($N^{subframe,u}_{slot}$) per subframe.

Table 1

| $u$ | $N^{slot}_{symb}$ | $N^{frame,u}_{slot}$ | $N^{subframe,u}_{slot}$ |
|---|---|---|---|
| 0 | 14 | 10 | 1 |
| 1 | 14 | 20 | 2 |

(continued)

| $u$ | $N^{slot}_{symb}$ | $N^{frame,u}_{slot}$ | $N^{subframe,u}_{slot}$ |
|---|---|---|---|
| 2 | 14 | 40 | 4 |
| 3 | 14 | 80 | 8 |
| 4 | 14 | 160 | 16 |

The table below shows the number of OFDM symbols per slot, the number of slots per frame, and the number of slots per subframe, according to the subcarrier spacing $\Delta f = 2^u*15$ kHz.

Table 2

| $u$ | $N^{slot}_{symb}$ | $N^{frame,u}_{slot}$ | $N^{subframe,u}_{slot}$ |
|---|---|---|---|
| 2 | 12 | 40 | 4 |

For a subcarrier spacing configuration u, slots may be indexed within a subframe in ascending order as follows: $n^u_s \in \{0, ..., n^{subframe,u}_{slot} - 1\}$ and indexed within a frame in ascending order as follows: $n^u_{s,f} \in \{0, ..., n^{ftame,u}_{slot} - 1\}$.

The slot includes multiple (e.g., 14 or 12) symbols in the time domain. For each numerology (e.g., subcarrier spacing) and carrier, a resource grid of $N^{size,u}_{grid,x}*N^{RB}_{sc}$ subcarriers and $N^{subframe,u}_{symb}$ OFDM symbols is defined, starting at a common resource block (CRB) $N^{start,u}_{grid}$ indicated by higher layer signaling (e.g., RRC signaling), where $N^{size,u}_{grid,x}$ is the number of resource blocks (RBs) in the resource grid and the subscript x is DL for downlink and UL for uplink. $N^{RB}_{sc}$ is the number of subcarriers per RB. In the 3GPP-based wireless communication system, $N^{RB}_{sc}$ is typically 12. There is one resource grid for a given antenna port $p$, a subcarrier spacing configuration $u$, and a transmission link (DL or UL). The carrier bandwidth $N^{size,u}_{grid}$ for the subcarrier spacing configuration $u$ is given to the UE by a higher layer parameter (e.g., RRC parameter). Each element in the resource grid for the antenna port $p$ and the subcarrier spacing configuration $u$ is referred to as a resource element (RE) and one complex symbol may be mapped to each RE. Each RE in the resource grid is uniquely identified by an index $k$ in the frequency domain and an index $l$ representing a symbol location relative to a reference point in the time domain. In the NR system, an RB is defined by 12 consecutive subcarriers in the frequency domain. In the NR system, RBs are classified into CRBs and physical resource blocks (PRBs). The CRBs are numbered from 0 upwards in the frequency domain for the subcarrier spacing configuration $u$. The center of subcarrier 0 of CRB 0 for the subcarrier spacing configuration $u$ is equal to 'Point A' which serves as a common reference point for RB grids. The PRBs for subcarrier spacing configuration $u$ are defined within a bandwidth part (BWP) and numbered from 0 to $N^{size,u}_{BWP,i}-1$, where i is a number of the BWP. The relation between a PRB $n_{PRB}$ in a BWP i and a CRB $n^u_{CRB}$ is given by: $n^u_{PRB} = n^u_{CRB} + N^{size,u}_{BWP,i}$, where $N^{size,u}_{BWP,i}$ is a CRB in which the BWP starts relative to CRB 0. The BWP includes a plurality of consecutive RBs in the frequency domain. For example, the BWP may be a subset of contiguous CRBs defined for a given numerology $u_i$ in the BWP i on a given carrier. A carrier may include a maximum of N (e.g., 5) BWPs. The UE may be configured to have one or more BWPs on a given component carrier. Data communication is performed through an activated BWP and only a predetermined number of BWPs (e.g., one BWP) among BWPs configured for the UE may be active on the component carrier.

The UE for which carrier aggregation is configured may be configured to use one or more cells. If the UE is configured with a plurality of serving cells, the UE may be configured with one or multiple cell groups. The UE may also be configured with a plurality of cell groups associated with different BSs. Alternatively, the UE may be configured with a plurality of cell groups associated with a single BS. Each cell group of the UE includes one or more serving cells and includes a single PUCCH cell for which PUCCH resources are configured. The PUCCH cell may be a Pcell or an Scell configured as the PUCCH cell among Scells of a corresponding cell group. Each serving cell of the UE belongs to one of cell groups of the UE and does not belong to a plurality of cells.

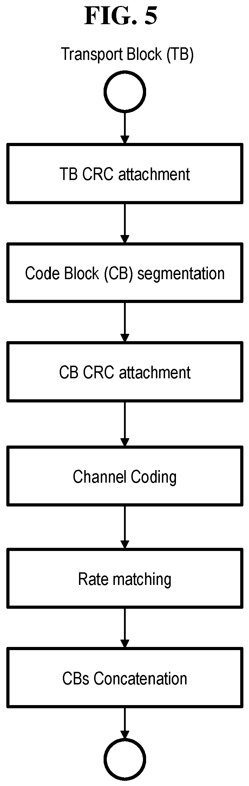

FIG. 5 illustrates a process for processing a transport block (TB) on a transmitting side.

In order for a receiving side to correct errors that radio signals experience in a radio channel, a transmitting side encodes information using a forward error correction code and then transmits the encoded information. The receiving side demodulates a received signal and decodes the error correction code to thereby recover the information transmitted by the transmitting side. In this decoding procedure, errors in the received signal caused by a radio channel are corrected.

Data arrives at a coding block in the form of a maximum of two transport blocks every transmission time interval (TTI) in each DL/UL cell. The following coding steps may be applied to each transport block of the DL/UL cell:

- cyclic redundancy check (CRC) attachment to a transport block;
- code block segmentation and CRC attachment to a code block;

- channel coding;
- rate matching; and
- code block concatenation.

In an actual communication system, a transport block of a predetermined size or larger is divided into a plurality of smaller data blocks and then is encoded, to facilitate actual implementation of coding. The smaller data blocks are called code blocks. While the code blocks are generally of the same size, one of the code blocks may have a different size due to a limited size of an internal interleaver of a channel encoder. Error correction coding is performed on each code block of a predetermined interleaver size and then interleaving is performed to reduce the impact of burst errors that are generated during transmission over a radio channel. The error-corrected and interleaved code block is transmitted by being mapped to an actual radio resource. The amount of radio resources used for actual transmission is designated. Thus, the encoded code blocks are rate-matched to the amount of the radio resources. In general, rate matching is performed through puncturing or repetition. For example, if the amount of radio resources, i.e., the number of transmission bits capable of being transmitted on the radio resources, is M and if a coded bit sequence, i.e., the number of output bits of the encoder, is N, in which M is different from N, then rate matching is performed to match the length of the coded bit sequence to M. If M>N, then all or a part of bits of the coded bit sequence are repeated to match the length of the rate-matched sequence to M. If M<N, then a part of the bits of the coded bit sequence is punctured to match the length of the rate-matched sequence to M and the punctured bits are excluded from transmission.

In wireless communication systems, the transmitting side encodes data to be transmitted based on channel coding with a specific code rate. Then, the transmitting side adjusts the code rate of the data to be transmitted through a rate matching process involving puncturing and repetition.

There are various types of error correction codes, but the size of an information block capable of achieving optimal performance is determined depending on the error correction code. While many coding schemes are available for achieving high-capacity information performance with long information block lengths, the majority of the coding schemes do not consistently show good performance over a wide range of information block lengths and code rates. However, turbo codes, low-density parity check (LPDC) codes, and polar codes show promising BLER performance in a wide range of coding rates and code lengths and hence are considered to be used in the NR system. As demand for various cases such as eMBB, massive IoT, and URLLC has increased, a coding scheme providing greater channel coding efficiency than in turbo codes is needed. In addition, increase in a maximum number of subscribers capable of being accommodated by a channel, i.e., increase in capacity, has been required. Polar codes among various error correction codes are codes providing a new framework capable of solving problems of legacy channel codes and were invented by Arikan at Bilkent University (reference: E. Arikan, "Channel Polarization: A Method for Constructing Capacity-Achieving Codes for Symmetric Binary-Input Memoryless Channels," in IEEE Transactions on Information Theory, vol. 55, no. 7, pp. 3051-3073, July 2009). Polar codes are the first capacity-achieving codes with low encoding and decoding complexities, which were proven mathematically. Polar codes outperform the turbo codes in large information block lengths while no error flow is present. Hereinafter, channel coding using the polar codes is referred to as polar coding.

Polar codes are known as codes capable of achieving the capacity of a given binary discrete memory less channel. This can be achieved only when a block size is sufficiently large. That is, polar codes are codes capable of achieving the capacity of a channel if the size N of the codes infinitely increases. Polar codes have low encoding and decoding complexity and may be successfully decoded. Polar codes are a sort of linear block error correction codes. Multiple recursive concatenations are basic building blocks for the polar codes and are bases for code construction. Physical conversion of channels in which physical channels are converted into virtual channels occurs and such conversion is based on a plurality of recursive concatenations. If multiple channels are multiplied and accumulated, most of the channels may become better or worse. The idea underlying polar codes is to use good channels. For example, data is sent through good channels at rate 1 and data is sent through bad channels at rate 0. That is, through channel polarization, channels enter a polarized state from a normal state.

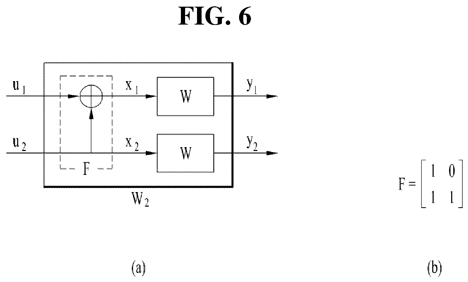

FIG. 6 is an example of a block diagram for a polar encoder.

FIG. 6(a) illustrates a base module of a polar code, particularly, first level channel combining for polar coding. In FIG. 6(a), W2 denotes an entire equivalent channel obtained by combining two binary-input discrete memory less channels (B-DMCs), Ws. Herein, $u_1$ and $u_2$ are binary-input source bits and $y_1$ and $y_2$ are output coded bits. Channel combining is a procedure of concatenating the B-DMCs in parallel.

FIG. 6(b) illustrates a base matrix F for the base module. The binary-input source bits $u_1$ and $u_2$ input to the base matrix F and the output coded bits $x_1$ and $x_2$ of the base matrix F have the following relationship.

Equation 1

$$[\,u_1\ \ u_2\,]\begin{bmatrix}1 & 0\\ 1 & 1\end{bmatrix}=[\,x_1\ \ x_2\,]$$

The channel W2 may achieve symmetric capacity I(W) which is a highest rate. In the B-DMC W, symmetric capacity is an important parameter which is used to measure a rate and is a highest rate at which reliable communication can occur over the channel W. The B-DMC may be defined as follows.

Equation 2

$$I(W) = \sum_{y\in Y}\sum_{x\in X}\frac{1}{2}W(y|x)\log\frac{w(y|x)}{\frac{1}{2}w(y|0)+\frac{1}{2}w(y|1)}$$

It is possible to synthesize or create a second set of N binary input channels out of N independent copies of a given B-DMC W and the channels have the properties $\{W_N^{(i)}: 1<=i<=N\}$. If N increases, there is a tendency for a part of the channels to have capacity approximating to 1 and for the remaining channels to have capacity approximating to 0. This is called channel polarization. In other words, channel polarization is a process of creating a second set of N channels $\{W_N^{(i)}: 1<=i<=N\}$ using N independent copies of a given B-DMC W. The effect of channel polarization means that, when N increases, all symmetric capacity terms $\{I(W_N^{(i)})\}$ tend towards 0 or 1 for all except a vanishing fraction of indexes i. In other words, the concept behind channel polarization in the polar codes is transforming N copies (i.e., N transmissions) of a channel having a symmetric capacity of I(W) (e.g., additive white Gaussian noise channel) into extreme channels of capacity close to 1 or 0. Among the N channels, an I(W) fraction will be perfect channels and an 1-I(W) fraction will be completely noise channels. Then, information bits are transmitted only through good channels and bits input to the other channels are frozen to 1 or 0. The amount of channel polarization increases along with a block length. Channel polarization consists of two phases: channel combining phase and channel splitting phase.

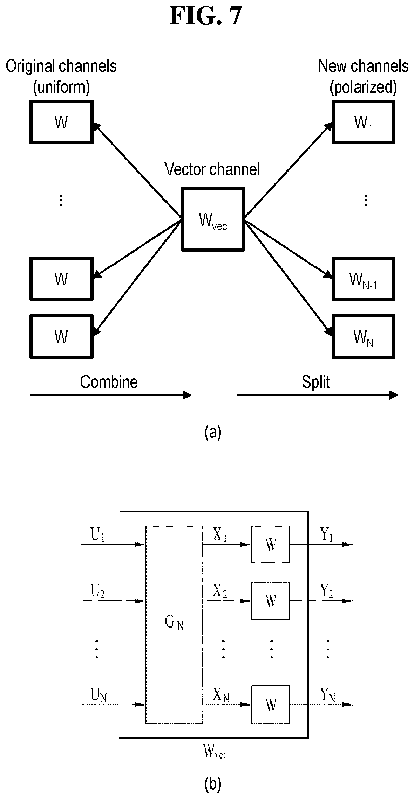

FIG. 7 illustrates the concept of channel combining and channel splitting for channel polarization. As illustrated in FIG. 7, when N copies of an original channel W are properly combined to create a vector channel $W_{vec}$ and then are split into new polarized channels, the new polarized channels are categorized into channels having capacity C(W)=1 and channels having capacity C(W)=0 if N is sufficiently large. In this case, since bits passing through the channels having the channel capacity C(W))=1 are transmitted without error, it is better to transmit information bits therethrough and, since bits passing through the channels having capacity C(W)=0 cannot transport information, it is better to transport frozen bits, which are meaningless bits, therethrough.

Referring to FIG. 7(a), copies of a given B-DMC W are combined in a recursive manner to output a vector channel $W_{vec}$ given by $X_N \to Y_N$, where $N=2^n$ and n is an integer equal to or greater than 0. Recursion always begins at the 0th level and $W_1 = W$. If n is 1 (n=1), this means the first level of recursion in which two independent copies of $W_1$ are combined. If the above two copies are combined, a channel $W_2: X_2 \to Y_2$ is obtained. A transitional probability of this new channel $W_2$ may be represented by the following equation.

Equation 3

$$W_2(y_1, y_2|u_1, u_2) = W(y_1|u_1 \oplus u_2)W(y_1|u_2)$$

If the channel $W_2$ is obtained, two copies of the channel $W_2$ are combined to obtain a single copy of a channel W4. Such recursion may be represented by W4: X4→Y4 having the following transitional probability.

Equation 4

$$W_4(y_1^4|u_1^4) = W_2(y_1^2|u_1 \oplus u_2, u_3 \oplus u_4)W_2(y_3^4|u_2, u_4)$$

In FIG. 7(b), $G_N$ is a size-N generator matrix. The relationship between input $u^N_1$ to $G_N$ and output $x^N_1$ of $G_N$ of FIG. 7(b) may be represented as $x^N_1 = u^N_1 G_N$, where $x^N_1 = \{x_1, ..., x_N\}$, $u^N_1 = \{u_1, ..., u_N\}$. When N B-DMCs are combined, each B-DMC may be expressed in a recursive manner. That is, $G_N$ may be indicated by the following equation.

Equation 5

$$G_N = B_N F^{\mathbf{W}n}$$

Herein, $\otimes$ denotes the Kronecker product, $N=2^n$, $n>=1$, $F^{\otimes n} = F \otimes F^{\otimes(n-1)}$, and $F^{\otimes 0} = 1$. $B_N$ is a permutation matrix known as a bit-reversal operation and $B_N = R_N(I_2 \otimes B_{N/2})$ and may be recursively computed. $I_2$ is a 2-dimensional identity matrix and this recursion is initialized to $B_2 = I_2$. $R_N$ is a bit-reversal interleaver and is used to map an input $s^N_1 = \{s_1, ..., s_N\}$ to an output $x^N_1 = \{s_1, s_3, ..., s_{N-1}, s_2, ..., s_N\}$. For example, $\mathbf{G}_2$ corresponds to a base matrix $\mathbf{F}$ shown in FIG. 6(b). $\mathbf{G}_4$ may be expressed as the following matrix.

Equation 6

$$G_4 = \begin{bmatrix} 1 & 0 & 0 & 0 \\ 0 & 0 & 1 & 0 \\ 0 & 1 & 0 & 0 \\ 0 & 0 & 0 & 1 \end{bmatrix} \begin{bmatrix} 1 & 0 \\ 1 & 1 \end{bmatrix}^{\otimes 2} = \begin{bmatrix} 1 & 0 & 0 & 0 \\ 1 & 0 & 1 & 0 \\ 1 & 1 & 0 & 0 \\ 1 & 1 & 1 & 1 \end{bmatrix}$$

A bit-reversal interleaver may not be included on the transmitting side. Without considering the bit-reversal interleaver, $\mathbf{G}_N$ may be expressed as $\mathbf{G}_N = (\mathbf{G}_2)^{\otimes n}$ (where $N=2^n$). $(\mathbf{G}_2)^{\otimes n}$ denotes the n-th Kronecker power of the matrix $\mathbf{G}_2$, where $\mathbf{G}_2$ is the same as the basic matrix F shown in FIG. 6(b).

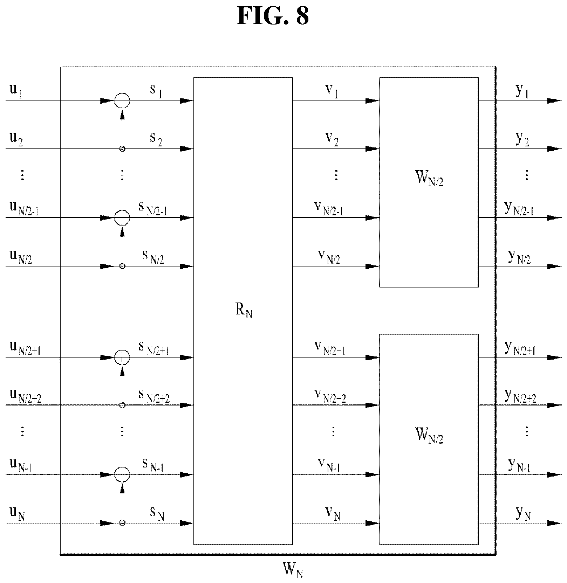

The relationship of Equation 5 is illustrated in FIG. 8.

FIG. 8 illustrates N-th level channel combining for a polar code.

A process of defining an equivalent channel for specific input after combining N B-DMCs Ws is called channel splitting. Channel splitting may be represented as a channel transition probability indicated by the following equation.

Equation 7

$$W_N^i\left(y_1^N, u_1^{i-1} \middle| u_i\right) = \sum_{u_{i+1}^N} \frac{1}{2^{N-1}} W_N\left(y_1^N \middle| u_1^N\right)$$

Channel polarization has the following characteristics:

> Conservation: $C(W^-) + C(W^+) = 2C(W)$,

> Extremization: $C(W^-) <= C(W) <= C(W^+)$.

When channel combining and channel splitting are performed, the following theorem may be obtained.

\* Theorem: For any B-DMC W, channels $\{W_N^{(i)}\}$ are polarized in the following sense. For any fixed $\delta \in \{0,1\}$, as N goes to infinity through powers of 2, the fraction of indexes $i \in \{1,...,N\}$ for channel capacity $I(W_N^{(i)}) \in (1-\delta,1]$ goes to I(W) and the faction of i for channel capacity $I(W_N^{(i)}) \in [0,\delta)$ goes to 1-I(W). Hence, if $N \to \infty$, then channels are perfectly noisy or are polarized free of noise. These channels can be accurately recognized by the transmitting side. Therefore, bad channels are fixed and non-fixed bits may be transmitted on good channels.

That is, if the size N of polar codes is infinite, a channel has much noise or is free of noise, with respect to a specific input bit. This has the same meaning that the capacity of an equivalent channel for a specific input bit is divided into 0 or I(W).

Inputs of a polar encoder are divided into bit channels to which information data is mapped and bit channels to which the information data is not mapped. As described earlier, according to the theorem of the polar code, if a codeword of the polar code goes to infinity, the input bit channels may be classified into noiseless channels and noise channels. Therefore, if information is allocated to the noiseless bit channels, channel capacity may be obtained. However, in actuality, a codeword of an infinite length cannot be configured, reliabilities of the input bit channels are calculated and data bits are allocated to the input bit channels in order of reliabilities. In the present disclosure, bit channels to which data bits are allocated are referred to as good bit channels. The good bit channels may be input bit channels to which the data bits are mapped. Bit channels to which data is not mapped are referred to as frozen bit channels. A known value (e.g., 0) is input to the frozen bit channels and then encoding is performed. Any values which are known to the transmitting side and the receiving side may be mapped to the frozen bit channels. When puncturing or repetition is performed, information about the good bit channels may be used. For example, positions of codeword bits (i.e., output bits) corresponding to positions of input bits to which information bits are not allocated may be punctured.

A decoding scheme of the polar codes is a successive cancellation (SC) decoding scheme. The SC decoding scheme obtains a channel transition probability and then calculates a likelihood ratio (LLR) of input bits using the channel transition probability. In this case, the channel transition probability may be calculated in a recursive form if channel combining and channel splitting procedures use characteristics of the recursive form. Therefore, a final LLR value may also be calculated in the recursive form. First, a channel transition probability $W_N^{(i)}(y_1^N, u_1^{i-1}|u_1)$ of an input bit $u_i$ may be obtained as follows. $u_1^i$ may be split into odd indexes and even indexes as expressed as $u_{1,o}^i$, $u_{1,e}^i$, respectively. The channel transition probability may be indicated by the following equations.

Equation 8

$$W_{2N}^{(2i-1)}(y_1^{2N}, u_1^{2i-1}|u_{2i-1})$$

$$= \sum_{u_{2i}^{2N}} \frac{1}{2^{2N-1}} W_{2N}(y_1^{2N}|u_1^{2N})$$

$$= \sum_{u_{2i,o}^{2N}, u_{2i,e}^{2N}} \frac{1}{2^{2N-1}} W_N(y_1^N|u_{1,o}^{2N} \oplus u_{i,e}^{2N}) W_N(y_{N+1}^{2N}|u_{1,e}^{2N})$$

$$= \sum_{u_{2i}} \frac{1}{2} \sum_{u_{2i+1,e}^{2N}} \frac{1}{2^{N-1}} W_N(y_{N+1}^{2N}|u_{1,e}^{2N}) \cdot \sum_{u_{2i+1,o}^{2N}} \frac{1}{2^{N-1}} W_N(y_1^N|u_{1,o}^{2N} \oplus u_{i,e}^{2N})$$

$$= \sum_{u_{2i}} \frac{1}{2} W_N^{(i)}(y_1^N, u_{1,o}^{2i-2} \oplus u_{i,e}^{2i-2}|u_{2i-1} \oplus u_{2i}) \cdot W_N^{(i)}(y_{N+1}^{2N}, u_{1,e}^{2i-2}|u_{2i})$$

where $\quad W_N^{(i)}(y_1^N, u_1^{i-1}|u_i) = \sum_{u_{i+1}^N} \frac{1}{2^{N-1}} W_N(y_1^N|u_1^N)$ .

Equation 9

$$W_{2N}^{(2i)}(y_1^{2N}, u_1^{2i-1}|u_{2i})$$

$$= \sum_{u_{2i+1}^{2N}} \frac{1}{2^{2N-1}} W_{2N}(y_1^{2N}|u_1^{2N})$$

$$= \sum_{u_{2i+1,o}^{2N}, u_{2i+1,e}^{2N}} \frac{1}{2^{2N-1}} W_N(y_1^N|u_{1,o}^{2N} \oplus u_{i,e}^{2N}) W_N(y_{N+1}^{2N}|u_{1,e}^{2N})$$

$$= \frac{1}{2} \sum_{u_{2i+1,e}^{2N}} \frac{1}{2^{N-1}} W_N(y_{N+1}^{2N}|u_{1,e}^{2N}) \cdot \sum_{u_{2i+1,o}^{2N}} \frac{1}{2^{N-1}} W_N(y_1^N|u_{1,o}^{2N} \oplus u_{i,e}^{2N})$$

$$= \frac{1}{2} W_N^{(i)}(y_1^N, u_{1,o}^{2i-2} \oplus u_{i,e}^{2i-2}|u_{2i-1} \oplus u_{2i}) \cdot W_N^{(i)}(y_{N+1}^{2N}, u_{1,e}^{2i-2}|u_{2i})$$

A polar decoder retrieves information and generates an estimate $u^\wedge{}_1^N$ of $u_1^N$ using values (e.g., reception bits, frozen bits, etc.) known for the polar codes. The LLR is defined as follows.

Equation 10

$$L_N^{(i)}(y_1^N, u_1^{i-1}) = \frac{W_N^{(i)}(y_1^N, u_1^{i-1}|u_i=0)}{W_N^{(i)}(y_1^N, u_1^{i-1}|u_i=1)}$$

The LLR may be recursively calculated as follows.

Equation 11

$$L_N^{(2i-1)}(y_1^N, \hat{u}_1^{2i-2}) = \frac{L_{N/2}^{(i)}(y_1^{N/2}, \hat{u}_{1,o}^{2i-2} \oplus \hat{u}_{1,e}^{2i-2}) \cdot L_{N/2}^{(i)}(y_{N/2+1}^N, \hat{u}_{1,e}^{2i-2}) + 1}{L_{N/2}^{(i)}(y_1^{N/2}, \hat{u}_{1,o}^{2i-2} \oplus \hat{u}_{1,e}^{2i-2}) + L_{N/2}^{(i)}(y_{N/2+1}^N, \hat{u}_{1,e}^{2i-2})}$$

$$L_N^{(2i)}(y_1^N, \hat{u}_1^{2i-1}) = [L_{N/2}^{(i)}(y_1^{N/2}, \hat{u}_{1,o}^{2i-2} \oplus \hat{u}_{1,e}^{2i-2})]^{1-2\hat{u}_{2i-1}} \cdot L_{N/2}^{(i)}(y_{N/2+1}^N, \hat{u}_{1,e}^{2i-2})$$

Recursive calculation of LLRs is traced back to a code length of 1 with an LLR $L_1^{(1)}(y_i) = W(y_i|0)/W(y_i|1)$. $L_1^{(1)}(y_i)$ is soft information observed from a channel.

The complexity of a polar encoder and an SC decoder varies with the length N of polar codes and is known as having $O(N\log N)$. Assuming that K input bits are used for a length-N polar code, a coding rate becomes N/K. If a generator matrix of a polar encoder of a data payload size N is $G_N$, an encoded bit may be represented as $x_1^N = u_1^N G_N$. It is assumed that K bits out of $u_1^N$ correspond to payload bits, a row index of $G_N$ corresponding to the payload bits is i, and a row index of $G_N$ corresponding to (N-K) bits is F. A minimum distance of the polar codes may be given as $d_{min}(C) = min_{i \in I} 2^{wt(i)}$, where wt(i) is the number of 1s within binary extension of i and i=0,1,...,N-1.

SC list (SCL) decoding is an extension of a basic SC decoder. In this type of decoder, L decoding paths are simultaneously considered in each decoding stage. Herein, L is an integer. In other words, in the case of the polar codes, a list-L decoding algorithm is an algorithm for simultaneously tracking L paths in a decoding process.

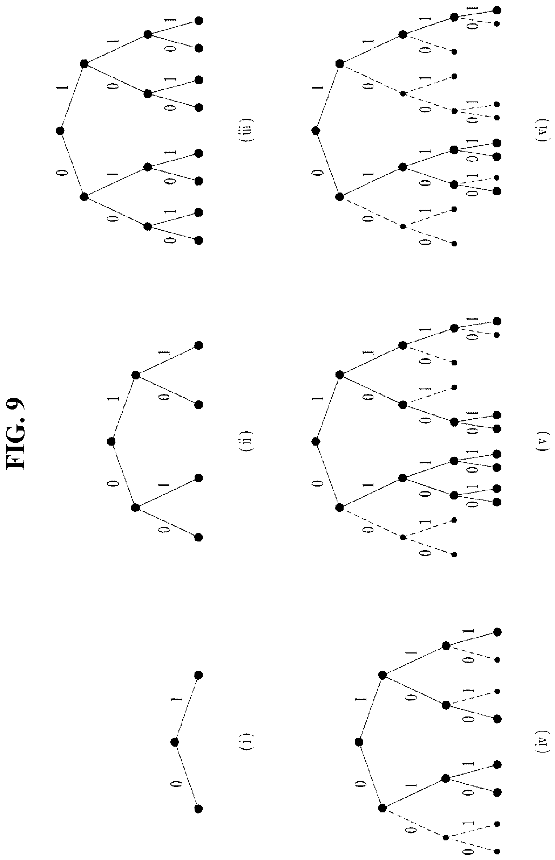

FIG. 9 illustrates an evolution of decoding paths in a list-L decoding process. For convenience of description, it is assumed that the number of bits that should be determined is n and all bits are not frozen. If a list size L is 4, each level includes at most 4 nodes with paths that continue downward. Discontinued paths are expressed by dotted lines in FIG. 9. A process in which decoding paths evolve in list-L decoding will now be described with reference to FIG. 9. i) If list-L decoding is started, the first unfrozen bit may be either 0 or 1. ii) list-L decoding continues. The second unfrozen bits may be either 0 or 1. Since the number of paths is not greater than L=4, pruning is not needed yet. iii) Consideration of all options for the first bit (i.e., a bit of the first level), the second bit (i.e. a bit of the second level), and the third bit (i.e. a bit of the third level) results in 8 decoding paths which are excessive because L=4. iv) the 8 decoding paths are pruned to L (=4) promising paths. v) 4 active paths continue by considering two options of the fourth unfrozen bit. In this case, the number of paths is doubled, i.e., 8 paths which are excessive because L=4. vi) The 8 paths are pruned back to L (=4) best paths. In the example of FIG. 7, 4 candidate codewords 0100, 0110, 0111, and 1111 are obtained and one of the codewords is determined to be a codeword most similar to an original codeword. In a similar manner to a normal decoding process, for example, in a pruning process or a process of determining a final codeword, a path in which the sum of LLR absolute values is largest may be selected as a survival path. If a CRC is present, the survival path may be selected through the CRC.

Meanwhile, CRC-aided SCL decoding is SCL decoding using CRC and improves the performance of polar codes. CRC is the most widely used technique in error detection and error correction in the field of information theory and coding. For example, if an input block of an error correction encoder has K bits and the length of information bits is k, and the length of CRC sequences is m bits, then K = k + m. CRC bits are a part of source bits for an error correction code. If the size of channel codes used for encoding is N, a code rate R is defined as R=K/N. CRC aided SCL decoding serves to detect an errorless path while a receiving device confirms a CRC code with respect to each path. An SCL decoder outputs candidate sequences to a CRC detector. The CRC detector feeds back a check result in order to aid in determining a codeword.

Although complicated as compared with an SC algorithm, SCL decoding or CRC aided SCL decoding has an advantage of excellent decoding performance. For more details of a list-L decoding algorithm of the polar codes, refer to 'I. Tal and A. Vardy, "List decoding of polar codes," in Proc. IEEE Int. Symp. Inf. Theory, pp. 1-5, Jul. 2011'.

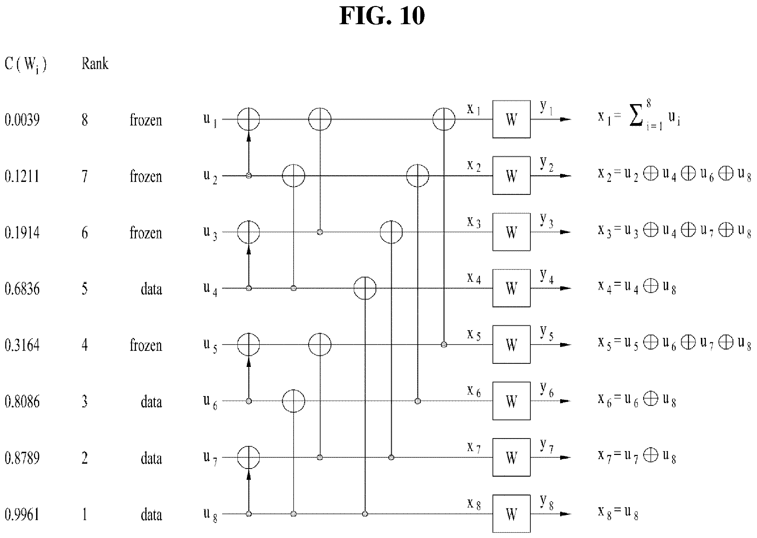

FIG. 10 illustrates the concept of selecting position(s) to which information bit(s) are to be allocated in polar codes.

In the example of FIG. 10, it is assumed that the size N of mother codes is 8, i.e., the size N of polar codes is 8, and a code rate is 1/2.

In FIG. 10, $C(W_i)$ denotes the capacity of a channel $W_i$ and corresponds to the reliability of channels that input bits of a polar code experience. When channel capacities corresponding to input bit positions of the polar code are as illustrated in FIG. 10, reliabilities of the input bit positions are ranked as illustrated in FIG. 10. To transmit data at a code rate of 1/2, a transmitting device allocates 4 bits constituting the data to 4 input bit positions having high channel capacities among 8 input bit positions (i.e., input bit positions denoted as $u_4$, $u_6$, $u_7$, and $u_8$ among input bit positions $u_1$ to $u_8$ of FIG. 10) and freezes the other input bit positions. A generator matrix $G_8$ corresponding to the polar code of FIG. 10 is as follows. The generator matrix $G_8$ may be acquired based on $(\mathbf{G}_2)^{\otimes n}$

Equation 12

$$G_8 = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

The input bit positions denoted as $u_1$ to $u_8$ of FIG. 10 correspond one by one to rows from the highest row to the lowest row of $G_8$. Referring to FIG. 10, it may be appreciated that the input bit corresponding to $u_8$ affects all output coded bits. On the other hand, it may be appreciated that the input bit corresponding to $u_1$ affects only $y_1$ among the output coded bits. Referring to Equation 12, when binary-input source bits $u_1$ to $u_8$ are multiplied by $G_8$, a row in which the input bits appear at all output bits is the lowest row [1, 1, 1, 1, 1, 1, 1, 1] in which all elements are 1, among rows of $G_8$. Meanwhile, a row in which the binary-input source bits appears at only one output bit is a row in which one element is 1 among the rows of $G_8$, i.e., a row [1, 0, 0, 0, 0, 0, 0, 0] in which a row weight is 1. Similarly, it may be appreciated that a row in which a row weight is 2 reflects input bits corresponding to the row in two output bits. Referring to FIG. 10 and Equation 12, $u_1$ to $u_8$ correspond one by one to the rows of $G_8$ and bit indexes for distinguishing between input positions of $u_1$ to $u_8$, i.e., bit indexes for distinguishing between the input positions, may be assigned to the rows of $G_8$.

Hereinafter, for Polar codes, it may be assumed that bit indexes from 0 to N-1 are sequentially allocated to rows of $G_N$ starting from the highest row having the smallest row weight with respect to N input bits. For example, referring to FIG. 10, a bit index 0 is allocated to the input position of $u_1$, i.e., the first row of $G_8$ and a bit index 7 is allocated to the input position of $u_8$, i.e., the last row of $G_8$. However, since the bit indexes are used to indicate input positions of the polar code, a scheme different from the above allocation scheme may be used. For example, bit indexes from 0 to N-1 may be allocated staring from the lowest row having the largest row weight.

In the case of output bit indexes, as illustrated in FIG. 10 and Equation 12, it may be assumed that bit indexes from 0 to N-1 or bit indexes from 1 to N are assigned to columns from the first column having the largest column weight to the last column having the smallest column weight among columns of $G_N$.

In Polar codes, setting of information bits and frozen bits is one of the most important elements in the configuration and performance of the polar code. That is, determination of ranks of input bit positions may be an important element in the performance and configuration of the polar code. For Polar codes, bit indexes may distinguish input or output positions of the polar code. In the present disclosure, a sequence obtained by enumerating reliabilities of bit positions in ascending or descending order are referred to as a bit index sequence or polar sequence. That is, the bit index sequence represents reliabilities of input or output bit positions of the polar code in ascending or descending order. A transmitting device inputs information bits to input bits having high reliabilities based on the input bit index sequence and performs encoding using the polar code. A receiving device may discern input positions to which information bits are allocated or input positions to which frozen bits are allocated, using the same or corresponding input bit index sequence. That is, the receiving device may perform polar decoding using an input bit index sequence which is identical to or corresponds to an input bit index sequence used by the transmitting device and using a corresponding polar code. In the following description, it may be assumed that an input bit index sequence is predetermined so that information bit(s) may be allocated to input bit position(s) having high reliabilities. In the present disclosure, the input bit index sequence is also called a Polar sequence.

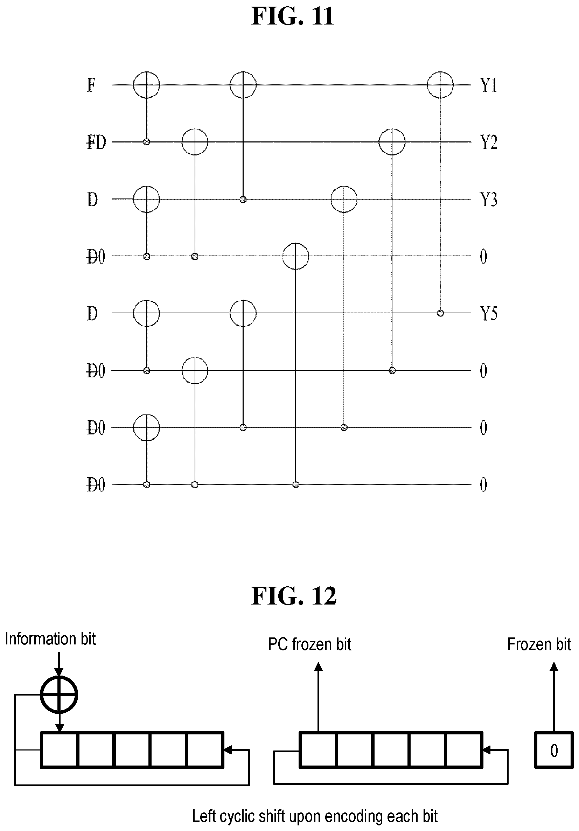

FIG. 11 illustrates puncturing and information bit allocation for polar codes. In FIG. 11, F denotes a frozen bit, D denotes an information bit, and 0 denotes a skipping bit.

Among coded bits, the case in which an information bit is changed to a frozen bit may occur according to an index or position of a punctured bit. For example, if output coded bits for a mother code of N=8 should be punctured in order of Y8, Y7, Y6, Y4, Y5, Y3, Y2, and Y1 and a target code rate is 1/2, then Y8, Y7, Y6, and Y4 are punctured, U8, U7, U6, and U4 connected only to Y8, Y7, Y6, and Y4 are frozen to 0, and these input bits are not transmitted, as illustrated in FIG. 9. An input bit changed to a frozen bit by puncturing of a coded bit is referred to as a skipping bit or a shortening bit and a corresponding input position is referred to as a skipping position or a shortening position. Shortening is a rate matching method of inserting a known bit into an input bit position connected to a position of an output bit desired to be transmitted while maintaining the size of input information (i.e., the size of information blocks). Shortening is possible starting from input corresponding to a column in which a column weight is 1 in a generator matrix $G_N$ and next shortening may be performed with respect to input corresponding to a column in which a column weight is 1 in a remaining matrix from which a column and row in which a column weight is 1 are removed. To prevent all information bits from being punctured, an information bit that should have been allocated to an information bit position may be reallocated in order of a high reliability within a set of frozen bit positions.

In the case of the polar code, decoding may be generally performed in the following order.

> 1. Bit(s) having low reliabilities are recovered first. Although reliability differs according to the structure of a decoder, since an input index in an encoder (hereinafter, an encoder input bit index or bit index) having a low value usually has a low reliability, decoding is generally performed staring from a low encoder input bit index.

> 2. When there is a known bit for a recovered bit, the known bit is used together with the recovered bit or the process of 1 is omitted and a known bit for a specific input bit position is immediately used, thereby recovering an information bit, which is an unknown bit. The information bit may be a source information bit (e.g., a bit of a transport block) or a CRC bit.

As explained earlier, the process of channel combining and channel splitting results in an equivalent channel being divided into a noisy channel and a noise-free channel. A data payload needs be transmitted over the noise-free channel. In other words, the data payload needs to be transmitted over the noise-free equivalent channel to achieve the desired performance. The noise-free equivalent channel may be determined by computing the value of the equivalent channel, $Z(W) = \sum \sqrt{W(y|0)W(y|1)}$ for each input bit. Z(W) is called the Battacharyya parameter, which may represent a value corresponding to the upper bound of the error probability when a MAP (maximum a posteriori probability) decision for transmission of binary input 0 or 1 is performed. Therefore, the transmitting side may obtain the values of Z(W), select equivalent channel(s) up to the size of the data payload in ascending order (e.g., decreasing order) of the values of Z(W), and use the equivalent channel(s) for transmission of the data payload. For a binary erasure channel (BEC), Z(W) may be obtained through Equation 13.

Equation 13

$$Z(W_N^{(i)}) = Z(W_{(b_1,b_2,...,b_{k-1})}) = \begin{cases} 2Z(W_{(b_1,b_2,...,b_{k-1})}) - Z(W_{(b_1,b_2,...,b_{k-1})})^2, & if\ b_k = 0 \\ Z(W_{(b_1,b_2,...,b_{k-1})})^2, & if\ b_k = 1 \end{cases}$$

For example, when the BEC has a binary probability of 0.5 and a code block size of 8, the values of Z(W) may be calculated according to Equation 11 as follows: Z(W) = {1.00, 0.68, 0.81, 0.12, 0.88, 0.19, 0.32, 0.00}. Thus, when the size of a data payload is 2, the data payload may be transmitted over equivalent channel 8 with Z(W) = 0.00 and equivalent channel 4 with Z(W) = 0.12.

As described above, since a polar encoder has different reliability depending on input positions, the transmitting side may allocate a data block (i.e., an information block before encoding) to bit channel(s) in order of reliability according to the size of the corresponding data block and perform encoding by setting all others to be frozen (e.g., with a value of '0'). For example, if the mother code size of the polar encoder (i.e., the maximum size of a code block that the polar encoder is capable of encoding) is N, and if the size of a data block input to the polar encoder is K, polar encoding is performed by arranging the bits of the data block in order of reliability in K bit channels and setting 0 to N-K bit channel(s).

The following shows the polar sequence used in NR (5G) systems (see the polar sequence defined in 3GPP TS 38.212 Rel-15).

<Polar sequence>

| W | I | W | I | W | I | W | I | W | I | W | I | W | I | W | I |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |

(continued)

| W | I | W | I | W | I | W | I | W | I | W | I | W | I | W | I |
|---|---|---|---|---|---|---|---|---|---|---|---|---|---|---|---|
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 26 | 170 | 105 | 298 | 337 | 426 | 424 | 554 | 454 | 682 | 679 | 810 | 745 | 938 | 980 |

(continued)

| W | I | W | I | W | I | W | I | W | I | W | I | W | I | W | I |
|---|---|---|---|---|---|---|---|---|---|---|---|---|---|---|---|
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |

(continued)

| W | I | W | I | W | I | W | I | W | I | W | I | W | I | W | I |
|---|---|---|---|---|---|---|---|---|---|---|---|---|---|---|---|
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |

(continued)

| W | I | W | I | W | I | W | I | W | I | W | I | W | I | W | I |
|---|---|---|---|---|---|---|---|---|---|---|---|---|---|---|---|
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

The above table shows a Polar sequence $\mathbf{Q}_0^{Nmax-1}$ and a reliability $W(Q_i^{Nmax})$ of the Polar sequence. In the above table, $W$ denotes $W(Q_i^{Nmax})$ and $I$ denotes $Q_i^{Nmax}$. Namely, the Polar sequence $\mathbf{Q}_0^{Nmax-1} = \{Q_0^{Nmax}, Q_1^{Nmax},.., Q_{Nmax-1}^{Nmax}\}$ is given by the above table, where $0<=Q_i^{Nmax}<=Nmax-1$ denotes a bit index (i.e., bit channel index) before Polar encoding for i=0,1,...,Nmax-1. For 3GPP TS 38.212 Rel-15, Nmax = 1024. The Polar sequence $\mathbf{Q}_0^{Nmax-1}$ is ascending order of reliability $W(Q_0^{Nmax})<W(Q_1^{Nmax})<...<W(Q_{Nmax-1}^{Nmax})$, where $W(Q_i^{Nmax})$ denotes the reliability of bit index $Q_i^{Nmax}$. For example, referring to the above table, a reliability $W(Q_i^{Nmax})=3$ of a bit index $Q_i^{Nmax}=4$ is lower than a reliability $W(Q_i^{Nmax})=7$ of bit index $Q_i^{Nmax}=3$. That is, the above table lists, in ascending order of reliability, bit indexes 0 to 1023 which respectively indicate 1024 input positions of a Polar code of Nmax= 1024.

For any information block encoded to N bits, a same Polar sequence $\mathbf{Q}_0^{N-1} = \{Q_0^N, Q_1^N, Q_2^N,..., Q_{N-1}^N\}$ is used. The Polar sequence $\mathbf{Q}_0^{N-1}$ is a subset of Polar sequence $\mathbf{Q}_0^{Nmax-1}$ with all elements $Q_i^{Nmax}$ of values less than N, ordered in ascending order of reliability $W(Q_0^N)<W(Q_1^N)<W(Q_2^N)<...<W(Q_{N-1}^N)$. For example, when N=8, a Polar sequence $\mathbf{Q}_0^7$ includes elements of $Q_i^{Nmax}<8$ among elements of the Polar sequence $\mathbf{Q}_0^{Nmax-1}$ and the elements of $Q_i^{Nmax}<8$ are ordered in ascending order of reliability $W(0)<W(1)<W(2)<W(4)<W(3)<W(5)<W(6)$.

For example, Table 3 lists input bit positions for an information block of size K (=10) input to a Polar code in a Polar sequence of N=512.

Table 3

| | Polar sequence |
|---|---|
| 1 | 505 |
| 2 | 506 |
| 3 | 479 |
| 4 | 508 |
| 5 | 495 |
| 6 | 503 |
| 7 | 507 |
| 8 | 509 |
| 9 | 510 |
| 10 | 511 |

Table 3 shows 10 elements for K=10 among elements of the Polar sequence of N=512 in ascending order of reliability. Referring to the above-described table of <Polar sequence>, values of I having 10 reliabilities $W(Q_i^{Nmax})$ among values of I (=$Q_i^{Nmax}$) less than N=512 are {479, 495, 503, 505, 506, 507, 508, 509, 510, 511}. If {479, 495, 503, 505, 506, 507, 508, 509, 510, 511} are arranged in ascending order of reliability $W$, {505, 506, 479, 508, 495, 503, 507, 509, 510, 511}, which is a set of bit indexes for K=10 in the Polar sequence of N=512 shown in Table 3, may be obtained.

If the bit sequence input to channel coding is denoted by $c_0,c_1,c_2,c_3,...,c_{K-1}$, the bits after encoding are denoted by $d_0,d_1,d_2,d_3,...,d_{N-1}$, where K is the number of bits to encode, where N=$2^n$ and the value of n is determined by the following table.

Table 4

$$\text{If } E \leq (9/8) \cdot 2^{(\lceil \log_2 E \rceil - 1)} \text{ and } K/E < 9/16$$

$$n_1 = \lceil \log_2 E \rceil - 1;$$

else

$$n_1 = \lceil \log_2 E \rceil;$$

end if

$$R_{min} = 1/8;$$

$$n_2 = \lceil \log_2 (K/R_{min}) \rceil;$$

$$n = \max\{\min\{n_1, n_2, n_{max}\}, n_{min}\}$$

where $n_{min} = 5$.

In Table 4, $n_{max}$ may be a value predetermined depending on the type of channel or control information and/or the number of information bits input into a channel coding block. For example, $n_{max}$ for a broadcast channel (BCH) may be predetermined as 9, $n_{max}$ for DCI may be predetermined as 9, and $n_{max}$ for UCI may be predetermined as 10.

In Table 4, E denotes a rate matching output sequence length. The rate matching output sequence length E may be predetermined depending on the type of channel, the type of control information, the amount of resources mapped to channel or control information, and/or the number of code blocks used for transmission of control information. For example, the rate matching output sequence length E for a BCH is 864, the rate matching output sequence length E for is 864, and the rate matching output sequence length E for UCI may be predetermined based on the number of OFDM symbols carrying the UCI, the number of RBs, a spreading factor, the number of code blocks for the UCI, and/or the type of UCI included in a UCI payload (e.g., HARQ-ACK, scheduling request (SR), channel state information (CSI), etc.).

For any information block encoded to N bits, a same Polar sequence $\mathbf{Q}_0^{N-1} = \{Q_0^N, Q_1^N, Q_2^N, ..., Q_{N-1}^N\}$ is used. The Polar sequence $\mathbf{Q}_0^{N-1}$ is a subset of Polar sequence $\mathbf{Q}_0^{Nmax-1}$ with all elements $Q_i^{Nmax}$ of values less than N, ordered in ascending order of reliability $W(Q_0^N) < W(Q_1^N) < W(Q_2^N) < ... < W(Q_{N-1}^N)$.

In the NR system, under specific conditions such as when 18 <= polar code information size <= 25, parity check bits are generated to improve performance (e.g., block error rate (BLER)) when using polar codes. Here, a polar code information size K refers to the number of information bits encoded through polar coding. For example, the sum of code block bits and code block CRC bit(s) may be equivalent to the polar code information size.

FIG. 12 illustrates a method of generating parity check bit(s) used in polar codes.

In some implementations, a parity check (PC) polar code may be used. The PC polar code refers to a polar code that places PC bit(s) generated using a portion of a data block (i.e., information block) in the input of a polar encoder. According to the currently published NR specifications, the PC polar code may be used when the data block size K is within a range of 18 <= K <= 25. In this case, the number of PC bits is 3, and the PC bits may be generated using a 5-bit shift register as illustrated in FIG. 12. In FIG.12, the 5-bit shift register, i.e., y[0], y[1], y[2], y[3], and y[4], are all initialized to 0. That is, PC bit(s) may be generated for a data block $[u_0, u_1, u_2, ..., u_{N-1}]$ as follows.

> The register is cyclically shifted to the left.
> If $u_i$ is an information bit, set y[0] = ($u_i$ XOR y[0]),
> If $u_i$ is a PC bit, set $u_i$ = y[0].

The generated PC bit(s) are assigned to input bit channels (i.e., the bit indices of the polar code) of the polar encoder as follows. When E - K + 3 > 192, $n^{wm}_{PC} = 1$, and when E - K + 3 <= 192, $n^{wm}_{PC} = 0$. In this case, if a set of bit indices for the PC bits is denoted as $\mathbf{Q}^N_{PC}$, and if a set of bit indices for other PC bits among $\mathbf{Q}^N_{PC}$ is denoted as $\mathbf{Q}^N_{PC\_wm}$, the size of the set $\mathbf{Q}^N_{PC}$ is $|\mathbf{Q}^N_{PC}| = n_{PC}$, and the size of the set $\mathbf{Q}^N_{PC\_wm}$ is $|\mathbf{Q}^N_{PC\_wm}| = n^{wm}_{PC}$. According to the NR specifications (e.g., 3GPP TS 38.212 Rel-15), $\mathbf{Q}^N_{PC}$ and $\mathbf{Q}^N_{PC\_wm}$ may be calculated as follows. For a bit index j ranging from 0 to N - 1 (i.e., j = 0, 1, ..., N-1), the j-th row of $\mathbf{G}_N$ is denoted as $\mathbf{g}_j$, and the row weight of $\mathbf{g}_j$ is denoted as $w(\mathbf{g}_i)$, where $w(\mathbf{g}_i)$ is the count

of ones within $\mathbf{g}_i$. In this case, $(n_{PC} - n^{wm}_{PC})$ PC bits are placed on $(n_{PC} - n^{wm}_{PC})$ least reliable bit indices in $\overline{\mathbf{Q}}_I^N$. In addition, the remaining $n^{wm}_{PC}$ PC bits are placed on bit indices with the minimum row weight in $\overline{\mathbf{Q}}_I^N$, where $\widetilde{\mathbf{Q}}_I^N$ denotes $\left(\left|\overline{\mathbf{Q}}_I^N\right| - n_{PC}\right)$ most reliable bit indices. If there are more bit indices with the same minimum row weight in $\widetilde{\mathbf{Q}}_I^N$ than $n^{wm}_{PC}$, the remaining $n^{wm}_{PC}$ PC bits are placed on $n^{wm}_{PC}$ bit indices with the highest reliability and the minimum row weight in $\widetilde{\mathbf{Q}}_I^N$.

The input to polar encoding, $\mathbf{u} = [u_0\ u_1\ u_2\ ...\ u_{N-1}]$ may be generated according to Table 5 below.

Table 5

$$k = 0;$$

$$\text{if } n_{PC} > 0$$

$$y_0 = 0; \; y_1 = 0; \; y_2 = 0; \; y_3 = 0; \; y_4 = 0;$$

$$\text{for } n = 0 \text{ to } N-1$$

$$y_t = y_0; \; y_0 = y_1; \; y_1 = y_2; \; y_2 = y_3; \; y_3 = y_4; \; y_4 = y_t;$$

$$\text{if } n \in \overline{\mathbf{Q}}_I^N$$

$$\text{if } n \in \mathbf{Q}_{PC}^N$$

$$u_n = y_0;$$

$$\text{else}$$

$$u_n = c_k';$$

$$k = k+1;$$

$$y_0 = y_0 \oplus u_n;$$

$$\text{end if}$$

$$\text{else}$$

$$u_n = 0;$$

$$\text{end if}$$

$$\text{end for}$$

$$\text{else}$$

$$\text{for } n = 0 \text{ to } N-1$$

$$\text{if } n \in \overline{\mathbf{Q}}_I^N$$

$$u_n = c_k';$$

$$k = k+1;$$

$$\text{else}$$

$$u_n = 0;$$

$$\text{end if}$$

$$\text{end for}$$

$$\text{end if}$$

The output after encoding, $\mathbf{d} = [d_0 \, d_1 \, d_2 \, d_3 \, ... \, d_{N-1}]$ is obtained from $\mathbf{d} = \mathbf{u}\mathbf{G}_N$, and the encoding is performed by GF(2).

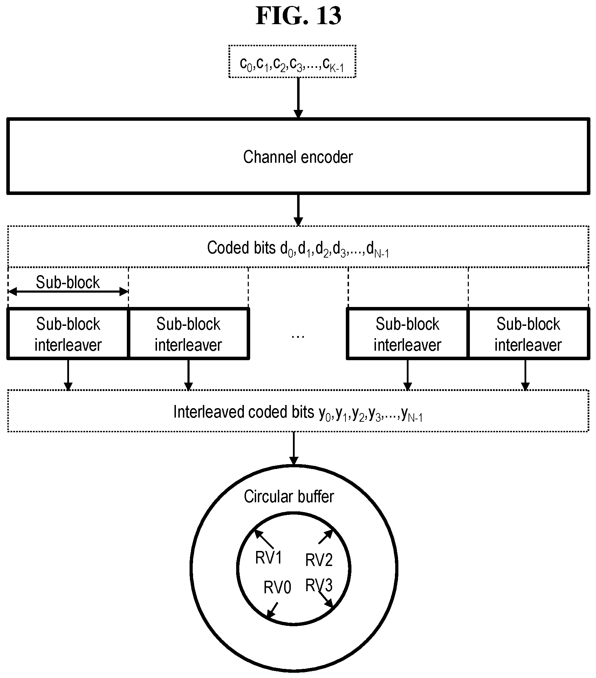

FIG. 13 is a diagram to explain a rate matching process according to some implementations of the present disclosure.

In some implementations, rate matching is performed after channel coding. In the NR specifications, rate matching for polar codes is defined for each code block, and the rate matching consists of sub-block interleaving, bit selection, and bit interleaving. In this specification, an input bit sequence before rate matching may be denoted as $d_0$, $d_1$,

$d_2$, $d_3$, ..., $d_{N-1}$, and an output bit sequence after rate matching may be denoted as $f_0$, $f_1$, $f_2$, $f_3$, ..., $f_{E-1}$. Bits input to a sub-block interleaver are coded bits $d_0$, $d_1$, $d_2$, $d_3$, ..., $d_{N-1}$. The coded bits $d_0$, $d_1$, $d_2$, $d_3$, ..., $d_{N-1}$ may be divided into 32 sub-blocks. Bits output from the sub-block interleaver may be denoted as $y_0$, $y_1$, $y_2$, $y_3$, ..., $y_{N-1}$, which may be generated as follows: for n = 0 to N-1: i = floor(32n / N); J(n) = P(i) * (N / 32) + mod(n, N / 32); $y_n = d_{J(n)}$, where a sub-block interleaver pattern P(i) is determined according to Table 6 below.

Table 6

| i | P(i) | i | P(i) | i | P(i) | i | P(i) | i | P(i) | i | P(i) | i | P(i) | i | P(i) |
|---|------|---|------|---|------|----|------|----|------|----|------|----|------|----|------|
| 0 | 0 | 4 | 3 | 8 | 8 | 12 | 10 | 16 | 12 | 20 | 14 | 24 | 24 | 28 | 27 |
| 1 | 1 | 5 | 5 | 9 | 16 | 13 | 18 | 17 | 20 | 21 | 22 | 25 | 25 | 29 | 29 |
| 2 | 2 | 6 | 6 | 10 | 9 | 14 | 11 | 18 | 13 | 22 | 15 | 26 | 26 | 30 | 30 |
| 3 | 4 | 7 | 7 | 11 | 17 | 15 | 19 | 19 | 21 | 23 | 23 | 27 | 28 | 31 | 31 |

$G_N = (G_2)^{\otimes n}$ denotes the n-th Kronecker power of the matrix $G_2$, where N is $2^n$ and $G_2$ is the same as the basic matrix F shown in FIG. 6(b).

In some implementations, the bit sequence $y_0$, $y_1$, $y_2$, $y_3$, ..., $y_{N-1}$ after the sub-block interleaver is written into a cyclic buffer of length N. If the rate matching output sequence length is denoted as E, a bit selection output bit sequence $e_k$ (where k = 0, 1, 2, ..., E-1) may be generated as follows.

Table 7

$$\text{if } E \geq N \quad \text{-- repetition}$$

$$\text{for } k = 0 \text{ to } E - 1$$

$$e_k = y_{\text{mod}(k,N)};$$

$$\text{end for}$$

$$\text{else}$$

$$\text{if } K/E \leq 7/16 \quad \text{-- puncturing}$$

$$\text{for } k = 0 \text{ to } E - 1$$

$$e_k = y_{k+N-E};$$

$$\text{end for}$$

$$\text{else} \quad \text{-- shortening}$$

$$\text{for } k = 0 \text{ to } E - 1$$

$$e_k = y_k;$$

$$\text{end for}$$

$$\text{end if}$$

$$\text{end if}$$

Puncturing or shortening is a technique where some of the encoded bits are not transmitted when resources allocated for transmission are not large enough to accommodate all the encoded bits. Repetition is a technique where some of the encoded bits are duplicated and transmitted when resources allocated for transmission are large enough to accommodate all the encoded bits.

Depending on the type of transport channel or control information or depending on the channel coding scheme, a bit sequence $e_0$, $e_1$, $e_2$, ..., $e_{E-1}$ may be interleaved into the bit sequence $f_0$, $f_1$, $f_2$, $f_3$, ..., $f_{E-1}$. For example, in the case of polar coding for UCI, the bit sequence $e_0$, $e_1$, $e_2$, ..., $e_{E-1}$ may be interleaved into the bit sequence $f_0$, $f_1$, $f_2$, $f_3$, ..., $f_{E-1}$ as follows.

Table 8

Denote $T$ as the smallest integer such that $T(T+1)/2 \geq E$;

$k = 0$;

for $i = 0$ to $T - 1$

   for $j = 0$ to $T - 1 - i$

      if $k < E$

         $v_{i,j} = e_k$;

      else

         $v_{i,j} = < NULL >$;

      end if

      $k = k + 1$;

   end for

end for

$k = 0$;

for $j = 0$ to $T - 1$

   for $i = 0$ to $T - 1 - j$

      if $v_{i,j} \neq < NULL >$

         $f_k = v_{i,j}$;

         $k = k + 1$

      end if

   end for

end for

else

   for $i = 0$ to $E - 1$

      $f_i = e_i$;

   end for

A set of bit indices in the polar sequence $\mathbf{Q}_0^{N-1}$ is denoted as $\overline{\mathbf{Q}}_I^N$, and a set of other bit indices in the polar sequence $\mathbf{Q}_0^{N-1}$ is denoted as $\overline{\mathbf{Q}}_F^N$, where $\left|\overline{\mathbf{Q}}_I^N\right| = K + n_{PC}$, $\left|\overline{\mathbf{Q}}_F^N\right| = N - \left|\overline{\mathbf{Q}}_I^N\right|$, and $n_{PC}$ is the number of PC bits. In the present disclosure, |S| denotes the number of elements in a set S. $\overline{\mathbf{Q}}_I^N$ and $\overline{\mathbf{Q}}_F^N$ are given as follows.

Table 9

$$\overline{\mathbf{Q}}^N_{F,tmp} = \varnothing$$

if $E < N$

    if $K/E \le 7/16$    -- puncturing

        for $n = 0$ to $N - E - 1$

$$\overline{\mathbf{Q}}^N_{F,tmp} = \overline{\mathbf{Q}}^N_{F,tmp} \cup \{J(n)\};$$

        end for

        if $E \ge 3N/4$

$$\overline{\mathbf{Q}}^N_{F,tmp} = \overline{\mathbf{Q}}^N_{F,tmp} \cup \{0,1,\ldots,\lceil 3N/4 - E/2 \rceil - 1\};$$

        else

$$\overline{\mathbf{Q}}^N_{F,tmp} = \overline{\mathbf{Q}}^N_{F,tmp} \cup \{0,1,\ldots,\lceil 9N/16 - E/4 \rceil - 1\};$$

        end if

    else    -- shortening

        for $n = E$ to $N - 1$

$$\overline{\mathbf{Q}}^N_{F,tmp} = \overline{\mathbf{Q}}^N_{F,tmp} \cup \{J(n)\};$$

        end for

    end if

end if

$$\overline{\mathbf{Q}}^N_{I,tmp} = \mathbf{Q}^{N-1}_0 \setminus \overline{\mathbf{Q}}^N_{F,tmp};$$

$$\overline{\mathbf{Q}}^N_I \text{ comprises } (K + n_{PC}) \text{ most reliable bit indices in } \overline{\mathbf{Q}}^N_{I,tmp};$$

$$\overline{\mathbf{Q}}^N_F = \mathbf{Q}^{N-1}_0 \setminus \overline{\mathbf{Q}}^N_I;$$

In the present disclosure, A\B denotes the difference of set B from set A, i.e., A - B. In other words, A\B refers to a set of all elements of set A that do not belong to set B.

To improve the performance of polar encoding/decoding, a polarization adjusted convolution (PAC) code that adopts convolution transform as a precoding operation before polar transform has been considered. The PAC code may improve error-correction performance of polar codes by concatenating the convolution transform with the polar transform.

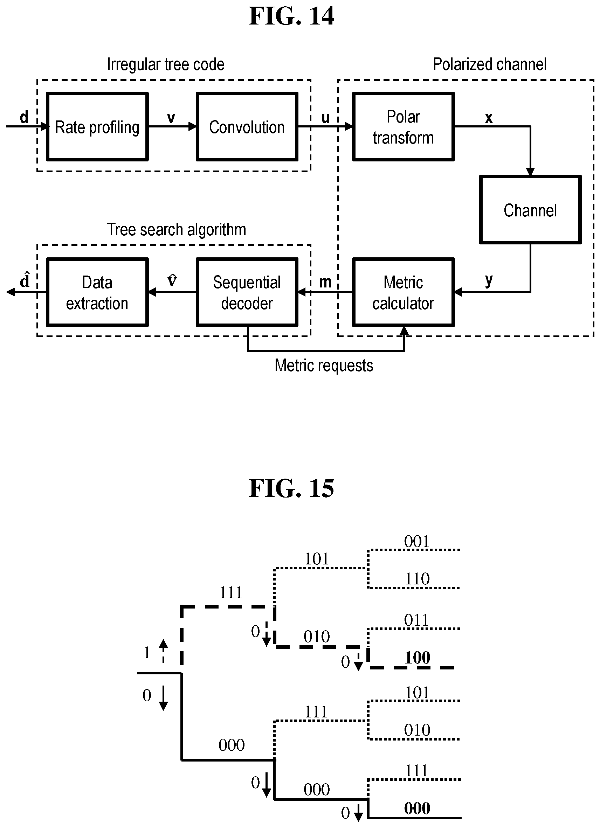

FIG. 14 illustrates a structure of one of encoders/decoders for a PAC code available for some implementations of the present disclosure.

As with typical polar codes, the overall performance of a PAC code depends on which locations in an input vector v to the convolution carry information and which locations are frozen to zero. This selection of frozen locations in the input vector v is called rate profiling.

Referring to FIG. 14, rate profiling in the PAC code classifies user data into an information set and a frozen set. For example, assuming a PAC code with mother code size N=8, when the user data size K=4, $\mathbf{d}$ = [$d_0$, $d_1$, $d_2$, $d_3$]. In this case, assuming a method of allocating the information/frozen bits according to the current NR standard, user data of size K is allocated to K bit channels in the order of bit channels 7, 6, 5, 3, 4, 2, 1, and 0, and thus the information set $\mathbf{A}$ = {7, 6, 5, 3} and the frozen set $\mathbf{A}^c$ = {4, 2, 1, 0}. The rate profiling maps user data $\mathbf{d}$ = [$d_0$, $d_1$, $d_2$, $d_3$] to $\mathbf{v}$= [$v_0$, ..., $v_7$], where $v_i$ is a value mapped to bit channel i. Thus, it may be represented as v = [0, 0, 0, $d_1$, 0, $d_2$, $d_3$, $d_4$]. The convolution operation may be performed by impulse response $\mathbf{c}$=($c_0$, ..., $c_m$), where $c_0 \neq 0$ and $c_m \neq 0$. A parameter m+1 is called a constraint length of the convolution. m is a size of a memory used for convolution, for example, the number of shift registers. In some implementations of the present disclosure, a convolution precoder may include m memory(s) (e.g., shift register(s)).

An input-output relation for convolution with a given impulse response $\mathbf{c}$=($c_0$, ..., $c_m$) is $$u_i = \sum_{j=0}^{m} c_j v_{i-j}$$ , where i=0,...,N-1, and $v_{i-j}$=0 when j>=i. If this is expressed as a matrix, it may be represented in the form of an upper triangular matrix as follows.

Equation 14

$$
\mathbf{T} = \begin{bmatrix}
c_0 & c_1 & c_2 & \cdots & c_m & 0 & \cdots & 0 \\
0 & c_0 & c_1 & c_2 & \cdots & c_m & \cdots & \vdots \\
0 & 0 & c_0 & c_1 & c_2 & \cdots & c_m & \vdots \\
\vdots & 0 & \ddots & \ddots & \ddots & \ddots & \ddots & \vdots \\
\vdots & \vdots & \ddots & \ddots & \ddots & \ddots & 0 & \vdots \\
\vdots & \vdots & \ddots & \ddots & 0 & c_0 & c_1 & c_2 \\
\vdots & \vdots & \ddots & \ddots & 0 & 0 & c_0 & c_1 \\
0 & \cdots & \cdots & \cdots & \cdots & 0 & 0 & c_0
\end{bmatrix}
$$

A polar variant $P_N$ of a mother code size N represents a polar code kernel matrix as shown in Equation 5. PAC codeword x may be represented as follows.

Equation 15

$$\mathbf{x} = \mathbf{vTP_N} = \mathbf{uP_N}$$

A decoding method of a PAC code may be broadly divided into two types. A first method performs sequential decoding by interpreting the convolution operation (i.e., convolution precoding) and the polar transform performed as convolution encoding with a constraint length N. Sequential decoding is heuristic decoding, various algorithms are known, and Fano decoding is known as an efficient method (refer to E. Arikan, "From sequential decoding to channel polarization and back again").

FIG. 15 illustrates a codeword tree for explaining a concept of sequential decoding. In an example of FIG. 15, it is assumed that input data is 100, a codeword resulting from encoding the input data 100 is 111 010 100, and the corresponding reception codeword at a receiver is 001 010 100.

Referring to FIG. 15, sequential decoding may be performed from left to right of the codeword tree. Referring to FIG. 15, for example, a decoder may perform decoding in a direction corresponding to 0 because 000 has a smaller (Hamming) distance value from among possible codewords 111 and 000 for a first codeword part 001 of the reception codeword 001 010 100. The decoder may perform decoding by comparing a second codeword part 010 of the reception codeword 001 010 100 with 111, 000 again to continue decoding in a direction of 0 corresponding to an input of 000, and comparing a third codeword part 100 with 111, 000 again to select 0, thereby obtaining a final value of 000. However, it is an error because the reception codeword is decoded to 000, which is a different value from the input data 100. Therefore, when a specific condition is generated to allow a decoder to perform decoding again at an upper node, it is possible to enable decoding without an error. In the example, when the first codeword part 001 is decoded and then is branched to the upper node and decoding is performed in a direction corresponding to 111 instead of 000, a decoding result of 100 may be obtained.

A brief description of Fano decoding for a convolution encoder with the number of input bits $\lambda$, the number of

output bits v, and constraint length L is as follows. When implementing decoding, a path metric may be represented as follows.

Equation 16

$$\Gamma_l = \sum_{n=1}^{l} \sum_{i=1}^{v} (\log \frac{P(y_n^{(i)} \mid x_n^{(i)})}{w(y_n^{(i)})} - B)$$

$$w(j) = \sum_{k=0}^{K-1} Q(k)P(j \mid k)$$

Here, 1 is a depth of the code tree, and where Q(k) is a relative frequency of k. In this case, update of the path depth may be represented as follows.

Equation 17

$$\Gamma_{l+1} = \Gamma_l + \sum_{i=1}^{v} (\log \frac{P(y_n^{(i)} \mid x_n^{(i)})}{w(y_n^{(i)})} - B)$$

The following table illustrates the Fano decoding algorithm.

Table 10

| | | Node Conditions | | Action | |
|---|---|---|---|---|---|
| | | Previous Move | Metric Comparison | Final Threshold | Move |
| | 1 | F or L | $\Gamma_{l\text{-}1} < T + \delta, \Gamma_l \geq T$ | Raise* | F† |
| | 2 | F or L | $\Gamma_{l\text{-}1} \geq T + \delta, \Gamma_l \geq T$ | No change | F† |
| | 3 | F or L | $\Gamma_l < T$ | No change | L or B‡ |
| | 4 | B | $\Gamma_{l\text{-}1} < T$ | Lower by Δ | F† |
| | 5 | B | $\Gamma_{l\text{-}1} \geq T$ | No change | L or B‡ |

In Table 10, * means adding jδ to a threshold, where j is selected to satisfy: $\Gamma_l \text{-} \delta < T + j\delta < \Gamma_l$. In Table 10, † means move forward to a first node stemming from a current node. In Table 10, ‡ means moving laterally to a next node that is different from the current node only in a last branch. If the current node is the last, move backward.

A second method performs the SC or SCL decoding described above by interpreting the convolution operation and polar transform as a polar code with precoding T applied. In this case, the SC/SCL decoding of the PAC code requires an SC/SCL decoder for conventional polar code, and storage of a memory state after performing convolution re-encoding during a decoding process. This is because, in the PAC code, an input of the polar transform is an output of the convolution encoder.

An example of an SCL decoding algorithm for a PAC code may be represented as in the following table (Reference: M. Rowshan, A. Burg, and E. Viterbo, "Polarization-adjusted convolutional (PAC) codes: sequential decoding vs list decoding," IEEE Tr. VT., vol. 70, no. 2, 2021).

Table 11

```
input  : channel LLRs λ_n^{0,N-1}, B, L, g
output: recovered message bits d̂
L ← {1}      // a single path in the list
[λ, β] ← [λ_n^{0,N-1}+{0}, {0}]
for i ← 0 to N − 1 do
    if i ∉ B then
        for l ← 1 to |L| do
            λ_0^i[l] ← updateLLRs(l, i, λ[l], β[l])
            v̂_i[l] ← 0
            [û_i[l], cState[l]] ← conv1bTrans(v_i, cState[l], g)
            PM_l^{(i)} ← calcPM(PM_l^{(i-1)}, λ_0^i[l], û_i[l])
            β[l] ← updatePartialSums(û_i[l], β[l])
    else
        for l ← 1 to |L| do
            L ← duplicatePath(L, l, i, g)
        if |L| > L then
            L ← prunePaths(L)            // like SCLD

d̂ ← extractData(v̂_1^N[0])
return d̂;

input  : profiled information bits v, g
output: the codeword x
u ← convTrans(v, g)
x ← polarTrans(u)      // Like polar encoder
return x;
subroutine convTrans(v, g):
    cState[1,...,|g| − 1] ← [0,...,0]     // currState
    for i ← 0 to |v| − 1 do
        (u_i, cState) ← conv1bTrans(v_i, cState, g)
    return u;

subroutine conv1bTrans(v, currState, g):
    u ← v · g_0
    for j ← 1 to |g| do
        if g_j = 1 then
            u ← u ⊕ currState[j − 1]
    nextState ← [v_i] + currState[1,...,|g| − 2]
    return (u, nextState);

subroutine duplicatePath(L, l, i, g):
    L ← L ∪ {l'}     // path l' is a copy of path l
    λ_0^i[l] ← updateLLRs(l, i, λ[l], β[l])
    (v̂_i[l], v̂_i[l']) ← (0, 1)
    [û_i[l], cState[l]] ← conv1bTrans(v̂_i[l], cState[l], g)
    [û_i[l'], cState[l']] ← conv1bTrans(v̂_i[l'], cState[l],
     g)
    PM_l^{(i)} ← calcPM(PM_l^{(i-1)}, λ_0^i[l], û_i[l])
    PM_{l'}^{(i)} ← calcPM(PM_l^{(i-1)}, λ_0^i[l], û_i[l'])
    β[l] ← updatePartialSums(û_i[l], β[l])
    β[l'] ← updatePartialSums(û_i[l'], β[l])
    return L;

subroutine calcPM(PM, λ_0, û):
    if û = ½(1 − sgn(λ_0)) then
        PM = PM
    else
        PM = PM + |λ_0|
    return PM;
```

Further generalizing the PAC code as in FIG. 14, it may be interpreted as a precoding in which a convolution operation matrix T is in the form of an upper triangular matrix. It is known that the precoded polar code may have improved minimum distance characteristics compared to a non-precoded polar code.

HARQ is a technology that combines forward error correction (FEC) and automatic repeat request (ARQ). For example, a transmitter transmits all or some of encoded coded bits by using FEC, and a receiver detects whether there is an error in the received data, and transmits a HARQ-ACK signal indicating an acknowledgement (ARQ) or negative ARQ (NACK) of the received data to the transmitter. If the transmitter determines that the data received at the receiver has no error or is below a certain threshold, the transmitter transmits new data, and in contrast, if the data received at the receiver contains an error, the transmitter retransmits the corresponding data block. The receiver combines the retransmitted data block with the previously transmitted data block and performs decoding again to detect an error. This operation may be performed until no error is detected or until a predetermined number of retransmissions are reached. The combining method for decoding the retransmitted data block may be divided into the following two types.

* Chase combining: For combining at a receiver, the transmitter retransmits coded bits that are identical to the coded bits that are initially transmitted. Chase combining may reduce an error probability through power gain when decoding the retransmitted data block.

* Incremental redundancy (IR): For combining at the receiver, the transmitter retransmits coded bits that are not identical to the coded bits initially transmitted. For example, the transmitter may transmit, to the receiver, redundancy that is not transmitted in the initial transmission in retransmission. In retransmission, redundancy that is not transmitted in the previous transmission is transmitted, and thus redundancy of the previous transmission and redundancy of the current transmission are combined to increase redundancy, which has an effect of lowering a code rate. That is, incremental redundancy may reduce an error probability through a coding gain during decoding of retransmitted data blocks. In general, chase combining corresponds to a case in which there is no incremental redundancy from among incremental redundancies, and thus chase combining may also be interpreted as a special form of incremental redundancy.

There are various types of HARQ schemes. For example, the HARQ schemes may be broadly categorized into synchronous HARQ schemes and asynchronous HARQ schemes based on the timing of retransmission. In addition, the HARQ schemes may be categorized into channel-adaptive schemes and channel-non-adaptive schemes depending on whether the channel state is reflected in the amount of resources to be used for retransmission.

In the case of the synchronous HARQ scheme, if the initial transmission fails, subsequent retransmission occurs at a timing determined by the system. For example, assuming that retransmission occurs every fourth time unit after the initial transmission fails, there is no need for the transmitter to inform the receiver of the timing of retransmission or for the receiver to inform the transmitter of the timing of retransmission because the timing is already determined between the transmitter and receiver. However, in the synchronous HARQ scheme, if the data transmitting side receives a NACK message, the data transmitting side retransmits a frame, for example, every fourth time unit, until receiving an ACK message. On the other hand, in the case of the asynchronous HARQ scheme, the timing of retransmission may be newly scheduled or provided through additional signaling (from the transmitter to the receiver or from the receiver to the transmitter). In the asynchronous HARQ scheme, the timing at which a previously failed frame is retransmitted varies depending on various factors such as channel states.

In the case of the channel-non-adaptive HARQ scheme, the frame modulation, the number of used RBs, adaptive modulation and coding (AMC), etc. for retransmission are determined to be the same as those determined for the initial transmission. In contrast, in the case of the channel-adaptive HARQ scheme, these parameters vary depending on the channel state. For example, in the channel-non-adaptive HARQ scheme, the transmitting side uses 6 RBs to transmit data during the initial transmission and also use 6 RBs for retransmission. On the other hand, in the channel-adaptive HARQ scheme, even if the transmitting side uses 6 RBs during the initial transmission, the transmitting side may use more or fewer RBs for retransmission based on the channel state.

According to the above classification, four different types of HARQ schemes may be used, but asynchronous and channel-adaptive HARQ schemes and synchronous and channel-non-adaptive HARQ schemes are commonly used. The asynchronous and channel-adaptive HARQ scheme may maximize retransmission efficiency by adaptively varying the retransmission timing and the amount of resources used based on the channel state. However, the asynchronous and channel-adaptive HARQ scheme may increase overhead, and thus, the asynchronous and channel-adaptive HARQ scheme is generally not considered for UL. On the other hand, the synchronous and channel-non-adaptive HARQ scheme has the advantage of minimal overhead because the timing and resource allocation for retransmission are predefined in the system. However, the synchronous and channel-non-adaptive HARQ scheme may when used in conditions with rapidly changing channel states. When the channel states change rapidly, the retransmission efficiency of the synchronous and channel-non-adaptive HARQ scheme may significantly degrade.

**<Increment Redundancy (IR) HARQ>**

In the current 3GPP-based wireless systems, the polar code has only been used for channel coding for a transport channel or control information with a small number of bits, such as broadcast channels (BCH), DCI, and UCI, and thus there has been little need to apply HARQ to an information block to which polar coding is applied. However, as wireless communication technology develops and the required services become more diverse, it may be considered to apply polar code-based channel coding to a data channel (e.g., uplink shared channel (UL-SCH), downlink shared channel (DL-SCH), and sidelink shared channel (SL-SCH)). In the future, when polar code-based channel coding is applied to data, a method for supporting HARQ for an information block to which polar code-based channel coding is applied is required. Hereinafter, implementations of the present disclosure for supporting HARQ for a polar code are described.

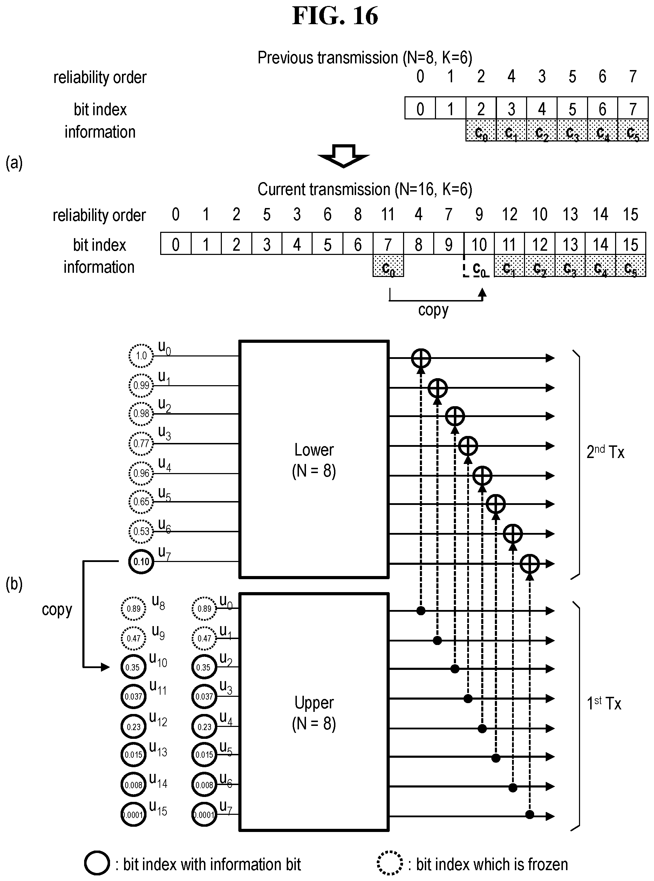

FIG. 16 illustrates examples of allocating information bits to a polar encoder according to some implementations of the present disclosure. In particular, FIG. 16 illustrates allocation of information bits for incremental redundancy (IR) to a polar encoding block, where the example of FIG. 16 assumes that a size of the data block (i.e., the size of the information block in polar encoding) K = 6, a mother code size N = 8 for initial transmission, and a mother code size N = 16 for retransmission. In the example of FIG. 16, reliability according to the Battacharyya parameter is assumed. In FIG. 16(a), it is assumed that a bit index with a larger reliability order value is a more reliable bit index. For example, a bit index with a reliability order value of 1 is assumed to be more reliable than a bit index with a reliability order value of 0. In FIG. 16(b), values in the input nodes are calculated Battacharyya parameters, and a smaller value indicates higher reliability.

To support incremental redundancy-based HARQ (hereinafter, IR HARQ) for a polar code, a transmitter may increase a mother code size when performing retransmission. For example, the transmitter may apply a mother code size N for initial transmission and a mother code size 2N for retransmission.

Referring to Fig. 16, in the case of the initial transmission, K = 6, and thus the transmitter performs polar encoding by placing bits $c_0, c_1, c_2, c_3, c_4,$ and $c_5$ of the data block in the most reliable bit indices 2, 3, 4, 5, 6, and 7 from among bit channel indices 0 to 7 (i.e., bit indices before polar encoding) of a mother code size N = 8. If the receiver determines that there is an error after decoding initial transmission and requests retransmission, or if the transmitter intends to perform retransmission in a case in which there is an error in initial transmission, the transmitter performs polar encoding by placing bits $c_0, c_1, c_2, c_3, c_4,$ and $c_5$ of the data block in six most reliable bit indices 7, 11, 12, 13, 14, and 15 from among bit indices 0 to 15 of the mother code size N = 16. However, to support the IR HARQ, the transmitter and the receiver need to satisfy the property that the coded bits generated in the initial transmission are provided in the coded bits generated in the retransmission. For example, referring to FIG. 16(a) and FIG. 16(b), in the current transmission, information bits $c_0, c_1, c_2, c_3, c_4,$ and $c_5$ need to be placed in bit indices in which information bits $c_0, c_1, c_2, c_3, c_4,$ and $c_5$ are placed in the previous transmission. When the mother code size increases from N to 2N, the polar encoded codeword may be represented as follows.

Equation 18

$$[U_2 \quad U_1]\begin{bmatrix} F & 0 \\ F & F \end{bmatrix} = [(U_1 + U_2)F \quad U_1 F]$$

Here, F is Kernel for polar encoding of a mother code size N, and $[U_2 \, U_1]$ is a data block. In this case, $U_1 F$ needs to be a codeword of initial transmission such that IR HARQ may be supported. Therefore, referring to FIG. 16, an operation in which data corresponding to bit index 7 is also allocated to a bit index 10 is required. That is, the same data bit needs to be placed in bit indices 7 and 10 and then encoded. Such a copy operation occurs if a mother code size increases for retransmission and a data block size is placed in bit indices of an upper polar encoder. That is, according to the example of FIG. 16, when N=16, an information bit is placed in bit index 7, which is the most reliable bit index from among the bit indices corresponding to a lower polar encoder when the data block size is greater than or equal to 5, and therefore the copy operation occurs. Hereinafter, polar subcodes of small bit indices are called lower polar subcodes, and the polar subcodes of large bit indices are called upper polar subcodes.

In the example of FIG. 16, the copy operation is described as copying a bit value mapped to a bit index of a lower polar subcode to a bit index of an upper polar subcode, but it may also be specified that the copy operation is performed from the upper polar subcode to the lower polar subcode. For example, referring to FIG. 16, a transmitter performing retransmission may place bits $c_0, c_1, c_2, c_3, c_4,$ and $c_5$ of data block in bit indices 9 to 15 of the polar code of the retransmission such that the upper polar subcode includes the mapping pattern to the polar code of the previous transmission, and copy bit $c_0$ placed in a bit index 10 to a bit index 7.

Hereinafter, implementations of the present disclosure supporting IR HARQ by using a PAC code are described.

**<HARQ design for PAC code with non-recursive convolution>**

The non-recursive convolution operation may be represented by the impulse response $\mathbf{c}=(c_0, ..., c_m)$. In this case, the constraint length is $m+1$. If the mother code size of the initial transmission is N, the polar transform may be represented in an N*N matrix. To obtain an IR gain during retransmission, the mother code size may be increased to 2N. In this case, both the convolution precoding matrix and the polar transform may be increased in size to 2N*2N matrices. For example, if a codeword of the initial transmission is expressed as in Equation 19, the codeword for retransmission may be represented as in Equation 20.

Equation 19

$$\mathbf{x}_1 = \mathbf{v}_1 \mathbf{T}_N \mathbf{P}_N$$

Equation 20

$$\mathbf{x}_2 = \begin{bmatrix} \mathbf{v}_2 & \mathbf{v}_1 \end{bmatrix} \mathbf{T}_{2N} \mathbf{P}_{2N} = \begin{bmatrix} \mathbf{v}_2 & \mathbf{v}_1 \end{bmatrix} \mathbf{T}_{2N} \begin{bmatrix} \mathbf{P}_N & 0 \\ \mathbf{P}_N & \mathbf{P}_N \end{bmatrix}$$

In Equation 19, $x_1$ and $v_1$ are 1*N matrices, and $\mathbf{T}_N$ and $\mathbf{P}_N$ are N*N matrices. $\mathbf{T}_N$ may be represented as follows.

Equation 21

$$\mathbf{T}_N = \begin{bmatrix} c_0 & c_1 & c_2 & \cdots & c_m & 0 & \cdots & 0 \\ 0 & c_0 & c_1 & c_2 & \cdots & c_m & \cdots & \vdots \\ 0 & 0 & c_0 & c_1 & c_2 & \cdots & c_m & \vdots \\ \vdots & 0 & \ddots & \ddots & \ddots & \ddots & \ddots & \vdots \\ \vdots & \vdots & \ddots & \ddots & \ddots & \ddots & 0 & \vdots \\ \vdots & \vdots & \ddots & \ddots & 0 & c_0 & c_1 & c_2 \\ \vdots & \vdots & \ddots & \ddots & 0 & 0 & c_0 & c_1 \\ 0 & \cdots & \cdots & \cdots & \cdots & 0 & 0 & c_0 \end{bmatrix}$$

In Equation 20, $x_2$ is a 1*2N matrix, $\mathbf{v}_2$ and $\mathbf{v}_2$ are 1*N matrices, and $\mathbf{T}_{2N}$ and $\mathbf{P}_{2N}$ are 2N*2N matrices and satisfy a relationship of $\mathbf{P}_{2N} = \begin{bmatrix} \mathbf{P}_N & 0 \\ \mathbf{P}_N & \mathbf{P}_N \end{bmatrix}$. $\mathbf{T}_{2N}$ may be represented as follows.

Equation 22

$$\mathbf{T}_{2N} = \begin{bmatrix} \mathbf{T}_N & \mathbf{T}_{N,tail} \\ 0 & \mathbf{T}_N \end{bmatrix}$$

Here, $\mathbf{T}_{N,tail}$ may be represented as follows.

Equation 23

$$\mathbf{T}_{N,tail} = \begin{bmatrix} 0 & 0 & \cdots & 0 & 0 & \cdots & 0 \\ \vdots & \vdots & \ddots & \vdots & \vdots & \vdots & \vdots \\ c_m & 0 & \ddots & \vdots & \vdots & \vdots & \vdots \\ \vdots & c_m & \ddots & \vdots & \vdots & \vdots & \vdots \\ \vdots & \vdots & \ddots & 0 & 0 & \cdots & 0 \\ c_1 & c_2 & \cdots & c_m & 0 & \cdots & 0 \end{bmatrix}$$

A codeword $\mathbf{x}_2$ at a time of retransmission may be represented as follows by using Equation 22.

Equation 24

$$
\begin{aligned}
\mathbf{x}_2 &= \begin{bmatrix} \mathbf{v}_2 & \mathbf{v}_1 \end{bmatrix} \begin{bmatrix} \mathbf{T}_N & \mathbf{T}_{N,tail} \\ 0 & \mathbf{T}_N \end{bmatrix} \begin{bmatrix} \mathbf{P}_N & 0 \\ \mathbf{P}_N & \mathbf{P}_N \end{bmatrix} \\
&= \begin{bmatrix} \mathbf{v}_2 & \mathbf{v}_1 \end{bmatrix} \begin{bmatrix} (\mathbf{T}_N + \mathbf{T}_{N,tail})\mathbf{P}_N & \mathbf{T}_{N,tail}\mathbf{P}_N \\ \mathbf{T}_N\mathbf{P}_N & \mathbf{T}_N\mathbf{P}_N \end{bmatrix} \\
&= \begin{bmatrix} \mathbf{v}_2(\mathbf{T}_N + \mathbf{T}_{N,tail})\mathbf{P}_N + \mathbf{v}_1\mathbf{T}_N\mathbf{P}_N & \mathbf{v}_2\mathbf{T}_{N,tail}\mathbf{P}_N + \mathbf{v}_1\mathbf{T}_N\mathbf{P}_N \end{bmatrix}
\end{aligned}
$$

To support IR HARQ, the codeword $\mathbf{x}_2$ of retransmission needs to include a codeword $\mathbf{v}_1\mathbf{T}_N\mathbf{P}_N$ of initial transmission, and thus Equation 24 needs to satisfy the following condition.

Equation 25

$$
\begin{aligned}
\mathbf{v}_2\mathbf{T}_{N,tail}\mathbf{P}_N + \mathbf{v}_1\mathbf{T}_N\mathbf{P}_N &= \mathbf{v}_1\mathbf{T}_N\mathbf{P}_N \\
\Rightarrow \mathbf{v}_2\mathbf{T}_{N,tail}\mathbf{P}_N &= 0
\end{aligned}
$$

The codeword for retransmission satisfying the condition of Equation 25 may be represented as follows.

Equation 26

$$
\begin{aligned}
\mathbf{x}_2 &= \begin{bmatrix} \mathbf{v}_2 & \mathbf{v}_1 \end{bmatrix} \mathbf{T}_{2N}\mathbf{P}_{2N} \\
&= \begin{bmatrix} \mathbf{v}_2\mathbf{T}_N\mathbf{P}_N + \mathbf{v}_1\mathbf{T}_N\mathbf{P}_N & \mathbf{v}_1\mathbf{T}_N\mathbf{P}_N \end{bmatrix}
\end{aligned}
$$

In some implementations of the present disclosure, the following methods may be considered to determine a solution satisfying the condition of Equation 25.

* Method 1: As a solution to $\mathbf{v}_2\mathbf{T}_{N,tail} = 0$, i.e., allocating 0 to last m bit location(s) of $\mathbf{v}_2$ to satisfy $\mathbf{v}_2\mathbf{T}_{N,tail} = 0$ may be considered. In other words, Method 1 may set the last part of a rate profile corresponding to $\mathbf{v}_2$ as frozen bit(s) equal to the number of memories for non-recursive convolution operation.

* Method 2: As a solution to $\mathbf{v}_2\mathbf{T}_{N,tail} = 0$, i.e., setting $\mathbf{T}_{N,tail} = 0$ to satisfy $\mathbf{v}_2\mathbf{T}_{N,tail} = 0$ may be considered. In this case, when calculating convolution, a part corresponding to $\mathbf{T}_{N,tail}$ is set to 0 and excluded from a target of the convolution, and thus it may be interpreted that a part of a codeword corresponding to the mother code size 2N is obtained through a different convolution than the other parts. Therefore, for Method 2, the receiver may need to modify its decoding operation when receiving the corresponding codeword. In Method 2, the precoding matrix $\mathbf{T}_{2N}$ applied during retransmission may be represented as follows.

Equation 27

$$\mathbf{T}_{2N} = \begin{bmatrix} \mathbf{T}_N & 0 \\ 0 & \mathbf{T}_N \end{bmatrix}$$

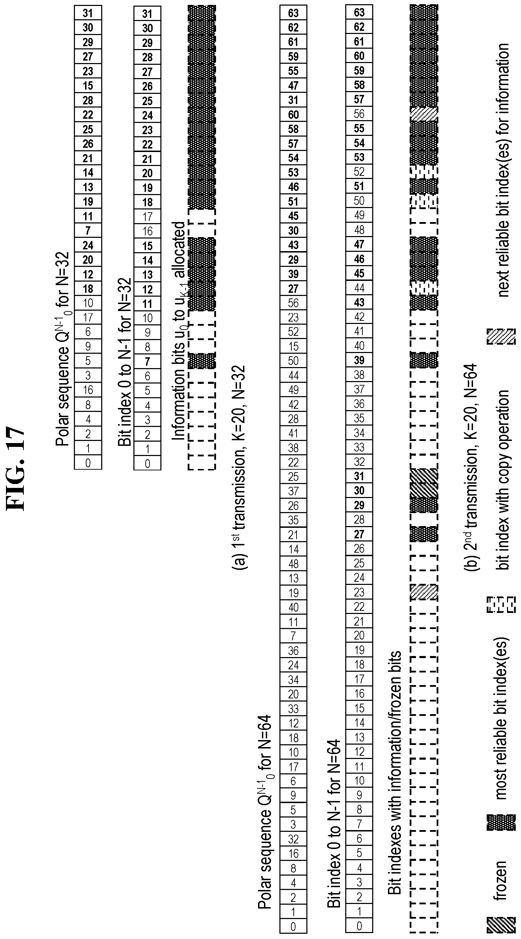

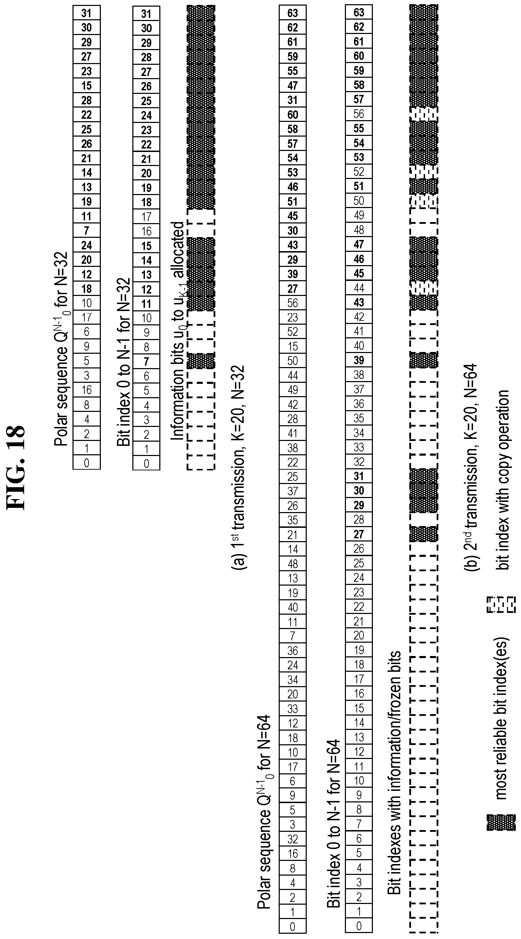

FIGS. 17 and 18 illustrate input sequences to convolution according to some implementations of the present disclosure. In particular, FIG. 17 illustrates examples of input to a convolution when a reliability order sequence (i.e., a polar sequence) defined in the current NR standard is applied to a rate profile according to Method 1, and FIG. 18 illustrates examples of input to a convolution when a polar sequence defined in the current NR standard is applied to a rate profile according to Method 2. In the examples of FIGS. 17 and 18, it is assumed that the mother code size of the initial transmission is N = 32, the mother code size of the retransmission is 2N = 64, the information size is K = 20, and the constraint length is m+1 = 3.

Referring to FIG. 17(a), for the initial transmission, information is allocated to bit indices {31, 30, 29, 27, 23, 15, 28, 22, 25, 26, 21, 14, 13, 19, 11, 7, 24, 20, 12, 18} according to a reliability order defined in the polar sequence. Referring to FIG. 17(b), if the mother code size increases to 64 for retransmission and the codeword of the initial transmission is placed in the lower 32 bits of a codeword for retransmission, the bit indices in which information of the initial transmission is to be placed from among the 64 bit indices of the mother code size 64 correspond to the bit indices {63, 62, 61, 59, 55, 47, 60, 54, 57, 58, 53, 46, 45, 51, 43, 39, 56, 52, 44, 50}. When the mother code size is 64, the bit indices to which 20-bit information is allocated according to the reliability order defined in the polar sequence are bit indices {63, 62, 61, 59, 55, 47, 31, 60, 58, 57, 54, 53, 46, 51, 45, 30, 43, 29, 39, 27}. However, according to the condition of Method 1, frozen bits are set in m = 2 bit indices {31, 30} from among the lower part of the rate profile (i.e., bit indices 0 to N-1 when the mother code size is 2N). Therefore, next reliable bit indices {56, 23} are selected as the bit indices to which information is to be allocated. Therefore, bit indices {63, 62, 61, 59, 55, 47, 60, 54, 57, 58, 53, 46, 45, 51, 43, 39, 56, 52, 44, 50, 27, 56, 23} may be determined as bit indices to which information is to be allocated.

Referring to FIG. 17(b), for retransmission, for example, information may be allocated to the most reliable 20 bit indices {63, 62, 61, 59, 55, 47, 60, 58, 57, 54, 53, 46, 51, 45, 43, 29, 39, 27, 56, 23} from among the bit indices {63, 62, 61, 59, 55, 47, 60, 54, 57, 58, 53, 46, 45, 51, 43, 39, 56, 52, 44, 50, 27, 56, 23}. To support IR HARQ, information needs to be allocated to bit indices {44, 50, 52}, and thus an operation of respectively copying information allocated to bit indices {23, 27, 29} to bit indices {44, 50, 52} may be performed. To support IR HARQ, the upper bit indices 32 to 63 of the 64-bit indices for retransmission may be set to include the bit values allocated to the 32-bit indices 0 to 31 for the initial transmission.

As another example, for retransmission, bit values placed in the bit indices {31, 30, 29, 27, 23, 15, 28, 22, 25, 26, 21, 14, 13, 19, 11, 7, 24, 20, 12, 18} for the initial transmission may be allocated in bit indices {63, 62, 61, 59, 55, 47, 60, 54, 57, 58, 53, 46, 45, 51, 43, 39, 56, 52, 44, 50} from among the bit indices {63, 62, 61, 59, 55, 47, 60, 54, 57, 58, 53, 46, 45, 51, 43, 39, 56, 52, 44, 50, 27, 56, 23} for information allocation, and bit values placed in bit indices {44, 50, 52} may be copied to bit indices {23, 27, 29}.

Referring to FIG. 18(a), for the initial transmission, information is allocated to bit indices {31, 30, 29, 27, 23, 15, 28, 22, 25, 26, 21, 14, 13, 19, 11, 7, 24, 20, 12, 18} according to a reliability order defined in the polar sequence. Referring to FIG. 18(b), if the mother code size increases to 64 for retransmission and the codeword of the initial transmission is placed in the lower 32 bits of the codeword for the retransmission, the bit indices in which information of the initial transmission is to be placed from among the 64 bit indices of the mother code size 64 correspond to the bit indices {63, 62, 61, 59, 55, 47, 60, 54, 57, 58, 53, 46, 45, 51, 43, 39, 56, 52, 44, 50}. When the mother code size is 64, the bit indices to which 20-bit information is allocated according to the reliability order defined in the polar sequence are bit indices {63, 62, 61, 59, 55, 47, 31, 60, 58, 57, 54, 53, 46, 51, 45, 30, 43, 29, 39, 27}. To support IR HARQ, information needs to be allocated to bit indices {44, 50, 52, 56}, and thus, for example, an operation of respectively copying information allocated to bit indices {27, 29, 30, 31} to bit indices {44, 50, 52, 56} may be performed. As another example, information allocated to bit indices {31, 30, 29, 27, 23, 15, 28, 22, 25, 26, 21, 14, 13, 19, 11, 7, 24, 20, 12, 18} in initial transmission using a PAC code of mother code size 32 may be allocated to bit indices {63, 62, 61, 59, 55, 47, 60, 54, 57, 58, 53, 46, 45, 51, 43, 39, 56, 52, 44, 50} in retransmission using a PAC code of a mother code size 64, and bits allocated to {44, 50, 52, 56} that do not belong to the most reliable 20-bit indices {63, 62, 61, 59, 55, 47, 31, 60, 58, 57, 54, 53, 46, 51, 45, 30, 43, 29, 39, 27} in a PAC code of a mother code size 64 from among bit indices {63, 62, 61, 59, 55, 47, 60, 54, 57, 58, 53, 46, 45, 51, 43, 39, 56, 52, 44, 50} may be copied to the next most reliable bit indices {27, 29, 30, 31}, respectively.

**<HARQ design for PAC code with recursive convolution>**

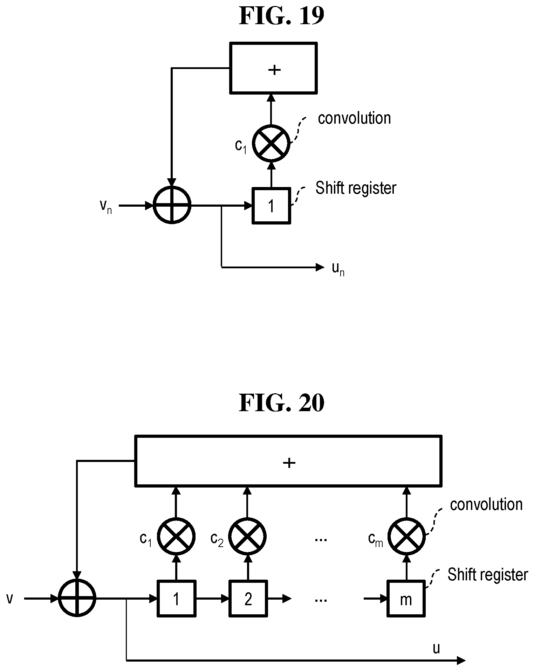

FIGS. 19 and 20 illustrate recursive convolution operations. In some implementations of the present disclosure, a convolution precoder may include m shift register(s). FIG. 19 illustrates an example of a recursive convolution precoder with the number of shift registers being 1, i.e., a constraint length of 2, and FIG. 20 illustrates an example of a recursive convolution precoder with the number of shift registers being m, i.e., a constraint length of m+1.

Referring to FIG. 19, $u_n$ may be determined by adding convolution of $u_{n-1}$ and $c_1$ stored in shift register 1 to $v_n$. In FIG. 19, if $c_1$ is 0, the result of convolution is always 0, and thus there is no constraint, which is the same as not applying convolution. Therefore, $c_1$ may be 1 in the example of FIG. 19, and thus a recursive convolution operation of FIG. 19 may be represented as $u_n = v_n + u_{n-1}$.

Referring to FIG. 20, an output $\mathbf{v}=[v_1, v_2, ..., v_N]$ obtained by performing a recursive convolution operation as in FIG. 20 for an input $\mathbf{u}=[u_1, u_2, ..., u_N]$ of a PAC code with a mother code size N may be represented as

$$u_n = v_n + \sum_{k=1}^{m} c_k u_{n-k}$$, where $u_0 = v_0$.

It is assumed that a rate profile output of initial transmission for a mother code size N is $\mathbf{v}^N=[v_0, v_1, ..., v_{N-1}]$ and a recursive convolution output is $\mathbf{u}^N=[u_0, u_1, ..., u_{N-1}]$. In this case, $u_n = v_n + \sum_{k=1}^{m} c_k u_{n-k}$. When a mother code size is 2N during retransmission, it is assumed that a rate profile output is $\mathbf{v}^{2N}=[v'_0, ..., v'_{N-1}, v_0, ..., v_{N-1}]$ and a recursive convolution output is $\mathbf{u}^{2N}=[u'_0, ..., u'_{N-1}, u_0, ..., u_{N-1}]$. To support IR HARQ, a codeword for retransmission corresponding to a mother code size 2N needs to include a codeword of initial transmission corresponding to a mother code size N. To this end, an output $u'_j = 0$, j = N-m,...,N-1 corresponding to a memory size of recursive convolution of the lower part of $\mathbf{u}^{2N}$ (i.e., if the mother code size is 2N, the bit indices are 0 to N-1) needs to be satisfied, which may be represented as the following equation. This condition is applied to ensure that the recursive convolution by the lower part does not affect the upper part (i.e., bit indices N to 2N-1 when the mother code size is 2N).

Equation 28

$$u'_j = v'_j + \sum_{k=1}^{m} c_k u'_{j-k} = 0, \quad j = N-m,...,N-1$$

$$\Rightarrow v'_j = \sum_{k=1}^{m} c_k u'_{j-k}, \quad j = N-m,...,N-1$$

In some implementations of the present disclosure, the transmitter sets an input bit sequence v to convolution such that the last m bit(s) of the lower part $[v'_0, ..., v'_{N-1}]$ of a rate profile output corresponding to a mother code size 2N satisfy the condition in Equation 28. The receiver may perform decoding assuming this operation of the transmitter.

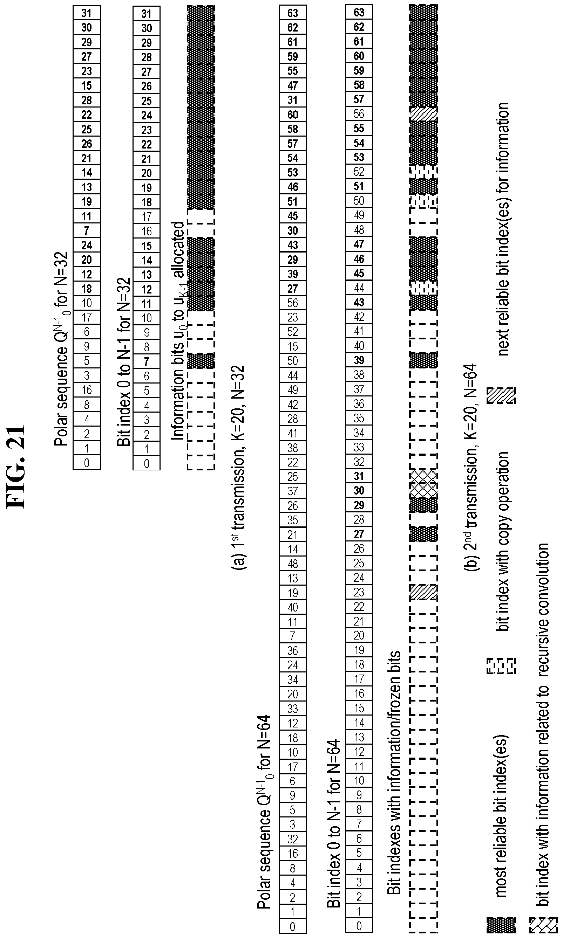

FIG. 21 illustrates an input sequence to convolution according to some implementations of the present disclosure. In particular, FIG. 21 illustrates an example an input to convolution according to some implementations of the present disclosure, which support IR HARQ for a PAC code for applying recursive convolution when applying a reliability order sequence (i.e., a polar sequence) defined in the current NR standard to a rate profile. In the examples of FIG. 21, it is assumed that the mother code size of the initial transmission is N = 32, the mother code size of the retransmission is 2N = 64, the information size is K = 20, and the constraint length is m+1 = 3.

In the example of FIG. 21, as in the example of FIG. 17, bit indices {63, 62, 61, 59, 55, 47, 60, 54, 57, 58, 53, 46, 45, 51, 43, 39, 56, 52, 44, 50, 27, 56, 23} may be determined as bit indices to which information is to be allocated. However, in the case of a PAC code that applies non-recursive convolution, a frozen bit is set in bit indices {31, 30} (see FIG. 17). In contrast, referring to FIG. 21, in the case of a PAC code having recursive convolution, a value $u'_{30}+u'_{29}$ and a value $u'_{29}+u'_{28}$ are set as bit values {$v'_{31}, v'_{30}$} corresponding to bit indices {31, 30}, respectively.

In some implementations of the present disclosure, for a PAC code of a size 2N having recursive convolution, the last m bit locations from among the uppermost N bit locations in the input bit sequence v to the convolution are set to value(s) satisfying Equation 28. The value(s) satisfying Equation 28 may vary depending on a memory size m and information input as a PAC code.

In some implementations of the present disclosure, when a PAC code of a size 2N having non-recursive or recursive convolution is applied for retransmission, the last m bit indices of the first N bit locations of an input bit sequence v to convolution are set with predetermined bit values (e.g., frozen bit value, or bit value satisfying Equation 28), and the K most reliable bit locations of the remaining (2N-m) bit locations are set with K bit values of the information block. To ensure that a codeword of retransmission may include a codeword for initial transmission, the information bit value(s) by or for the copy operation may be set in the next most reliable $K_{copy}$ bit location(s), where $K_{copy}$ is the number of bit indices in which the copy operation is performed.

Some implementations of the present disclosure may support HARQ for data communications that apply a PAC code. Therefore, according to some implementations of the present disclosure, the throughput of a wireless communication system may be improved due to support of a PAC code and HARQ.

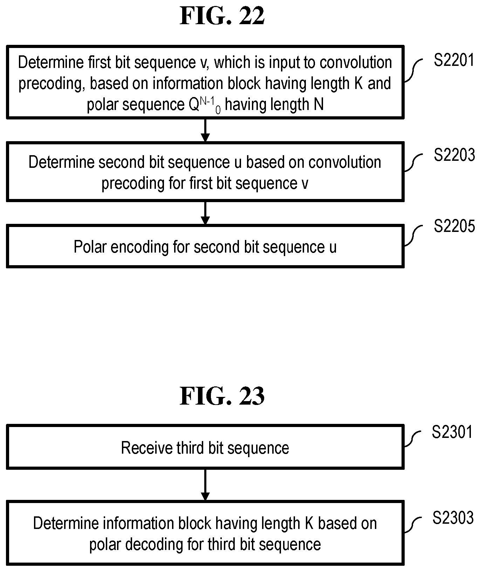

FIG. 22 illustrates a channel encoding process according to some implementations of the present disclosure.

A communication device or encoder may perform operations related to channel encoding according to some implementations of the present disclosure. The communication device may include: at least one transceiver; at least one processor; and at least one computer memory operably connected to the at least one processor and storing instructions that, when executed, cause the at least one processor to perform operations according to some implementations of the present disclosure. A processing device for the communication device or encoder may include: at least one processor; and at least one computer memory operably connected to the at least one processor and storing instructions that, when executed, cause the at least one processor to perform the operations according to some implementations of the present disclosure. A computer-readable (non-volatile) storage medium may store at least one computer program including instructions that, when executed by at least one processor, cause the at least one processor to perform the operations according to some implementations of the present disclosure. A computer program or computer program product may include instructions that are recorded in at least one computer-readable (non-volatile) storage medium and cause, when executed, (at least one processor) to perform the operations according to some implementations of the present disclosure.

Referring to FIG. 22, in the method performed by the communication device, in the communication device, the encoder, the processing device, the computer-readable (non-volatile) storage medium, and/or the computer program product, the operations may include determining a first bit sequence $\mathbf{v}^{2N} = \{v_0,....v_{2N-1}\}$, which is an input to convolution precoding, based on the information block having a length K and a polar sequence $\mathbf{Q}^{2N-1}_0 = \{Q_0, Q_1,...,Q_{2N-1}\}$ having a length 2N (S2201), determining a second bit sequence $\mathbf{u}^{2N} = \{u_0,...,u_{2N-1}\}$ based on performing the convolution precoding on the first bit sequence (S2203), and performing polar encoding on the second bit sequence (S2205). The polar sequence $\mathbf{Q}^{2N-1}_0 = \{Q_0, Q_1, ..., Q_{2N-1}\}$ having a length 2N is defined in ascending order of reliability $W(Q^{2N}_0)<W(Q^{2N}_1) <...<W(Q^{2N}_{2N-1})$, where $0 <= Q^{2N}_i <= 2N - 1$ is a bit index for i = 0, 1, ..., 2N - 1, and $W(Q^{2N}_i)$ is reliability of bit index $Q^{2N}_i$. The determining of the first bit sequence $\mathbf{v}^{2N}$ may include mapping predetermined bit values to the last m bit indices from among first N bit indices in the first bit sequence $\mathbf{v}^{2N}$ and mapping K bit values of the information block to K bit indices from among the remaining (2N-m) bit indices, where m is the number of shift registers for convolution precoding.

In some implementations, the method or the operations may include determining a third bit sequence including coded bits obtained via polar encoding for the second bit sequence. The determining of the third bit sequence may include determining a rate-matched output sequence of a length E through rate matching.

In some implementations, the method or the operations may include transmitting the third bit sequence to another communication device.

In some implementations, the mapping of the predetermined bit values to the last m bit indices may include mapping a frozen bit value to each of the last m bit indices. For example, the mapping of the predetermined bit values to the last m bit indices may include mapping 0 to each of the last m bit indices.

In some implementations, the performing the convolution precoding on the first bit sequence may include determining the second bit sequence $\mathbf{u}^{2N} = \{u_0,...,u_{2N-1}\}$ based on $u_n = v_n + \sum_{k=1}^{m} c_k u_{n-k}$, where $c_k$ is an element of an impulse response $\mathbf{c}=(c_0, ..., c_m)$, k=0,...,m, $u_n$ is an element of the second bit sequence, n=0,...,2N-1, and $u_0 = v_0$.

In some implementations, the mapping of the predetermined bit values to the last m bit indices may include mapping $v_j$ to satisfy $v'_j = \sum_{k=1}^{m} c_k u'_{j-k}$, where j = N-m, ..., N-1.

In some implementations, the mapping of the K bits of the information block to the K bit indices from among the remaining (2N-m) bit indices may include mapping the K bit values of the information block to K most reliable bit indices from among the remaining (2N-m) bit indices based on the polar sequence $\mathbf{Q}^{2N-1}_0 = \{Q_0, Q_1, ..., Q_{2N-1}\}$ of a length 2N.

FIG. 23 illustrates a channel decoding process according to some implementations of the present disclosure.

A communication device or decoder may perform operations related to channel decoding according to some implementations of the present disclosure. The communication device may include: at least one transceiver; at least one processor; and at least one computer memory operably connected to the at least one processor and storing instructions that, when executed, cause the at least one processor to perform operations according to some implementations of the present disclosure. A processing device for the communication device or decoder may include: at least one processor; and at least one computer memory operably connected to the at least one processor and storing instructions that, when executed, cause the at least one processor to perform the operations according to some implementations of the present disclosure. A computer-readable (non-volatile) storage medium may store at least one computer program including instructions that, when executed by at least one processor, cause the at least one processor to perform the operations according to some implementations of the present disclosure. A computer program or computer program product may include instructions that are recorded in at least one computer-readable (non-volatile) storage medium and cause, when executed, (at least one processor) to perform the operations according to some implementations of the present disclosure.

Referring to FIG. 23, in the method performed by the communication device, in the communication device, the decoder, the processing device, the computer-readable (non-volatile) storage medium, and/or the computer program product, the operations may include receiving a third bit sequence including coded bits (S2301), and obtaining the information block having a length K based on the third bit sequence (S2303). The third bit sequence may be provided based on polar encoding for the second bit sequence $\mathbf{u}^{2N} = \{u_0,...,u_{2N-1}\}$. The second bit sequence may be provided via convolution precoding for the first bit sequence $\mathbf{v}^{2N} = \{v_0,...,v_{2N-1}\}$. The first bit sequence $\mathbf{v}^{2N}$ may be provided based on the information block of a length K and a polar sequence $\mathbf{Q}^{2N-1}_0 = \{Q_0, Q_1, ..., Q_{2N-1}\}$ of a length 2N. The polar sequence $\mathbf{Q}^{2N-1}_0 = \{Q_0, Q_1, ..., Q_{2N-1}\}$ having a length 2N is defined in ascending order of reliability $W(Q^{2N}_0)<W(Q^{2N}_1)< ... <W(Q^{2N}_{2N-1})$, where $0 <= Q^{2N}_i <= 2N - 1$ is a bit index for i = 0, 1, ..., 2N - 1, and $W(Q^{2N}_i)$ is reliability of bit index $Q^{2N}_i$. From among the first N bit indices in the first bit sequence $\mathbf{v}^{2N}$, the last m bit indices may include predetermined bit values, and from among the remaining (2N-m) bit indices, K bit indices may include K bit values of the information block, where m is the number of shift registers for the convolution precoding.

In some implementations, the last m bit indices may be frozen. For example, the last m bit indices may include 0 in $v_j$ as the predetermined bit values.

In some implementations, the second bit sequence may be provided based on the first bit sequence $v^{2N} = \{v_0,...,v_{2N-1}\}$ and $u_n = v_n + \sum_{k=1}^{m} c_k u_{n-k}$ , where $c_k$ is an element of an impulse response c=$(c_0, ..., c_m)$, k=0,...,m, $u_n$ is an element of the second bit sequence, n=0,...,2N-1, and $u_0 = v_0$.

In some implementations, $v_j$ from among the last m bit indices may include a bit value satisfying: $v'_j = \sum_{k=1}^{m} c_k u'_{j-k}$ , where j = N-m, ..., N-1.

In some implementations, the K-bit indices from among the remaining (2N-m) bit indices may be the most reliable K-bit indices based on the polar sequence $\mathbf{Q}^{2N-1}_0 = \{Q_0, Q_1, ..., Q_{2N-1}\}$ of a length 2N.

The examples of the present disclosure as described above have been presented to enable any person of ordinary skill in the art to implement and practice the present disclosure. Although the present disclosure has been described with reference to the examples, those skilled in the art may make various modifications and variations in the example of the present disclosure. Thus, the present disclosure is not intended to be limited to the examples set for the herein, but is to be accorded the broadest scope consistent with the principles and features disclosed herein.

The implementations of the present disclosure may be used in a BS, a UE, or other equipment in a wireless communication system.

## Claims

1. A method of transmitting an information block by a communication device in a wireless communication system, the method comprising:

    determining a first bit sequence $\mathbf{v}^{2N} = \{v_0,...,v_{2N-1}\}$, which is an input to convolution precoding, based on the information block of length K and a polar sequence $\mathbf{Q}^{2N-1}_0 = \{Q_0, Q_1, ..., Q_{2N-1}\}$ of length 2N;
    determining a second bit sequence $\mathbf{u}^{2N} = \{u_0,...,u_{2N-1}\}$ based on performing the convolution precoding on the first bit sequence;
    determining a third bit sequence including bits coded based on polar encoding for the second bit sequence; and
    transmitting the third bit sequence to another communication device,
    wherein the polar sequence $\mathbf{Q}^{2N-1}_0 = \{Q_0, Q_1, ..., Q_{2N-1}\}$ of length 2N is defined in ascending order of reliability $W(Q^{2N}_0)<W(Q^{2N}_1)< ... <W(Q^{2N}_{2N-1})$, where $0 <= Q^{2N}_i <= 2N - 1$ is a bit index for i = 0, 1, ..., 2N - 1, and $W(Q^{2N}_i)$ is reliability of bit index $Q^{2N}_i$, and
    wherein determining the first bit sequence $v^{2N}$ includes mapping predetermined bit values to last m bit indices from among first N bit indices in the first bit sequence $v^{2N}$ and mapping K bit values of the information block to K bit indices from among remaining (2N-m) bit indices, where m is a number of shift registers for the convolution precoding.

2. The method of claim 1, wherein mapping the predetermined bit values to the last m bit indices comprises mapping 0 to the last m bit indices.

3. The method of claim 1, wherein performing the convolution precoding on the first bit sequence comprises:

    determining the second bit sequence $\mathbf{u}^{2N} = \{u_0,...,u_{2N-1}\}$ based on $u_n = v_n + \sum_{k=1}^{m} c_k u_{n-k}$ , where $c_k$ is an element of an impulse response $\mathbf{c}=(c_0, ..., c_m)$, k=0,...,m, $u_n$ is an element of the second bit sequence, n=0,...,2N-1,

and $u_0 = v_0$.

4. The method of claim 3, wherein mapping the predetermined bit values to the last m bit indices comprises mapping $v_j$ to satisfy $v'_j = \sum_{k=1}^{m} c_k u'_{j-k}$ , where j = N-m, ..., N-1.

5. The method of claim 1, wherein mapping the K bits of the information block to the K bit indices from among the remaining (2N-m) bit indices comprises mapping K bit values of the information block to K most reliable bit indices from among the remaining (2N-m) bit indices based on the polar sequence $\mathbf{Q}^{2N-1}_0 = \{Q_0, Q_1, ..., Q_{2N-1}\}$ of length 2N.

6. A communication device for transmitting an information block in a wireless communication system, the communication device comprising:

at least one transceiver;
at least one processor; and
at least one computer memory operably connected to the at least one processor and storing instructions that, when executed, cause the at least one processor to perform operations including:

determining a first bit sequence $\mathbf{v}^{2N} = \{v_0,...,v_{2N-1}\}$, which is an input to convolution precoding, based on the information block of a length K and a polar sequence $\mathbf{Q}^{2N-1}_0 = \{Q_0, Q_1, ..., Q_{2N-1}\}$ of length 2N;
determining a second bit sequence $\mathbf{u}^{2N} = \{u_0,...,u_{2N-1}\}$ based on performing the convolution precoding on the first bit sequence;
determining a third bit sequence including bits coded based on polar encoding for the second bit sequence; and
transmitting the third bit sequence to another communication device,
wherein the polar sequence $\mathbf{Q}^{2N-1}_0 = \{Q_0, Q_1, ..., Q_{2N-1}\}$ of length 2N is defined in ascending order of reliability $W(Q^{2N}_0)<W(Q^{2N}_1)< ... <W(Q^{2N}_{2N-1})$, where $0 <= Q^{2N}_i <= 2N - 1$ is a bit index for i = 0, 1, ..., 2N - 1, and $W(Q^{2N}_i)$ is reliability of bit index $Q^{2N}_i$, and
wherein determining the first bit sequence $v^{2N}$ includes mapping predetermined bit values to last m bit indices from among first N bit indices in the first bit sequence $v^{2N}$ and mapping K bit values of the information block to K bit indices from among remaining (2N-m) bit indices, where m is a number of shift registers for the convolution precoding.

7. A processing device in a wireless communication system, the processing device comprising:

at least one processor; and
at least one computer memory operably connected to the at least one processor and storing instructions that, when executed, cause the at least one processor to perform operations including:

determining a first bit sequence $\mathbf{v}^{2N} = \{v_0,... ,v_{2N-1}\}$, which is an input to convolution precoding, based on an information block of length K and a polar sequence $\mathbf{Q}^{2N-1}_0 = \{Q_0, Q_1, ..., Q_{2N-1}\}$ of length 2N;
determining a second bit sequence $\mathbf{u}^{2N} = \{u_0,...,u_{2N-1}\}$ based on performing the convolution precoding on the first bit sequence;
determining a third bit sequence including bits coded based on polar encoding for the second bit sequence; and
transmitting the third bit sequence to another communication device,
wherein the polar sequence $\mathbf{Q}^{2N-1}_0 = \{Q_0, Q_1, .., Q_{2N-1}\}$ of length 2N is defined in ascending order of reliability $W(Q^{2N}_0)<W(Q^{2N}_1)< ... <W(Q^{2N}_{2N-1})$, where $0 <= Q^{2N}_i <= 2N - 1$ is a bit index for i = 0, 1, ..., 2N - 1, and $W(Q^{2N}_i)$ is reliability of bit index $Q^{2N}_i$, and
wherein determining the first bit sequence $v^{2N}$ includes mapping predetermined bit values to last m bit indices from among first N bit indices in the first bit sequence $\mathbf{v}^{2N}$ and mapping K bit values of the information block to K bit indices from among remaining (2N-m) bit indices, where m is a number of shift registers for the convolution precoding.

8. A computer-readable storage medium storing at least one computer program code including instructions that, when executed, cause at least one processor to perform operations, the operations comprising:

determining a first bit sequence $\mathbf{v}^{2N} = \{v_0,...,v_{2N-1}\}$, which is an input to convolution precoding, based on an information block of length K and a polar sequence $\mathbf{Q}^{2N-1}{}_0 = \{Q_0, Q_1, ..., Q_{2N-1}\}$ of length 2N;

determining a second bit sequence $\mathbf{u}^{2N} = \{u_0,...,u_{2N-1}\}$ based on performing the convolution precoding on the first bit sequence;

determining a third bit sequence including bits coded based on polar encoding for the second bit sequence; and transmitting the third bit sequence to another communication device,

wherein the polar sequence $\mathbf{Q}^{2N-1}{}_0 = \{Q_0, Q_1, ..., Q_{2N-1}\}$ of length 2N is defined in ascending order of reliability $W(Q^{2N}{}_0) < W(Q^{2N}{}_1) < ... < W(Q^{2N}{}_{2N-1})$, where $0 <= Q^{2N}{}_i <= 2N - 1$ is a bit index for i = 0, 1, ..., 2N - 1, and $W(Q^{2N}{}_i)$ is reliability of bit index $Q^{2N}{}_i$, and

wherein determining the first bit sequence $v^{2N}$ includes mapping predetermined bit values to last m bit indices from among first N bit indices in the first bit sequence $\mathbf{v}^{2N}$ and mapping K bit values of the information block to K bit indices from among remaining (2N-m) bit indices, where m is a number of shift registers for the convolution precoding.

9. A method of receiving an information block by a communication device in a wireless communication system, the method comprising:

receiving a third bit sequence including coded bits; and

obtaining the information block of length K based on the third bit sequence,

wherein the third bit sequence is provided based on polar encoding for a second bit sequence $\mathbf{u}^{2N} = \{u_0,...,u_{2N-1}\}$,

wherein the second bit sequence is provided via convolution precoding for a first bit sequence $\mathbf{v}^{2N} = \{v_0,...,v_{2N-1}\}$,

wherein the first bit sequence $\mathbf{v}^{2N}$ is provided based on the information block of length K and a polar sequence $\mathbf{Q}^{2N-1}{}_0 = \{Q_0, Q_1, ..., Q_{2N-1}\}$ of length 2N,

wherein the polar sequence $\mathbf{Q}^{2N-1}{}_0 = \{Q_0, Q_1, ..., Q_{2N-1}\}$ of length 2N is defined in ascending order of reliability $W(Q^{2N}{}_0) < W(Q^{2N}{}_1) < ... < W(Q^{2N}{}_{2N-1})$, where $0 <= Q^{2N}{}_i <= 2N - 1$ is a bit index for i = 0, 1, ..., 2N - 1, and $W(Q^{2N}{}_i)$ is reliability of bit index $Q^{2N}{}_i$, and

wherein, from among first N bit indices in the first bit sequence $\mathbf{v}^{2N}$, last m bit indices include predetermined bit values, and from among remaining (2N-m) bit indices, K bit indices include K bit values of the information block, where m is a number of shift registers for the convolution precoding.

10. The method of claim 9, wherein the last m bit indices include 0 in $v_j$ as the predetermined bit values.

11. The method of claim 9, wherein the second bit sequence is provided based on the first bit sequence $v^{2N} = \{v_0,...,v_{2N-1}$

$$u_n = v_n + \sum_{k=1}^{m} c_k u_{n-k}$$

12. and , where $c_k$ is an element of an impulse response $\mathbf{c} = (c_0, ..., c_m)$, k=0,...,m, $u_n$ is an element of the second bit sequence, n=0,...,2N-1, and $u_0 = v_0$.

13. The method of claim 11, wherein $v_j$ from among the last m bit indices includes a bit value satisfying

$$v'_j = \sum_{k=1}^{m} c_k u'_{j-k}$$ , where j = N-m, ..., N-1.

14. The method of claim 9, wherein the K bit indices from among the remaining (2N-m) bit indices are most reliable K bit indices based on the polar sequence $\mathbf{Q}^{2N-1}{}_0 = \{Q_0, Q_1, ..., Q_{2N-1}\}$ of length 2N.

15. A communication device for receiving an information block in a wireless communication system, the communication device comprising:

at least one transceiver;

at least one processor; and

at least one computer memory operably connected to the at least one processor and storing instructions that, when executed, cause the at least one processor to perform operations including:

receiving a third bit sequence including coded bits; and

obtaining the information block of length K based on the third bit sequence,

wherein the third bit sequence is provided based on polar encoding for a second bit sequence $\mathbf{u}^{2N} = \{u_0,...,u_{2N-1}\}$,

wherein the second bit sequence is provided via convolution precoding for a first bit sequence $\mathbf{v}^{2N} = \{v_0,...,v_{2N-1}\}$,

wherein the first bit sequence $\mathbf{v}^{2N}$ is provided based on the information block of length K and a polar sequence $\mathbf{Q}^{2N-1}_0 = \{Q_0, Q_1, ..., Q_{2N-1}\}$ of length 2N,

wherein the polar sequence $\mathbf{Q}^{2N-1}_0 = \{Q_0, Q_1, ..., Q_{2N-1}\}$ of length 2N is defined in ascending order of reliability $W(Q^{2N}_0) < W(Q^{2N}_1) < ... < W(Q^{2N}_{2N-1})$, where $0 <= Q^{2N}_i <= 2N-1$ is a bit index for $i = 0, 1, ..., 2N-1$, and $W(Q^{2N}_i)$ is reliability of bit index $Q^{2N}_i$, and

wherein, from among first N bit indices in the first bit sequence v2N, last m bit indices include predetermined bit values, and from among remaining (2N-m) bit indices, K bit indices include K bit values of the information block, where m is a number of shift registers for the convolution precoding.

16. A processing device in a wireless communication system, the processing device comprising:

   at least one processor; and
   at least one computer memory operably connected to the at least one processor and storing instructions that, when executed, cause the at least one processor to perform operations including:

      receiving a third bit sequence including coded bits; and
      obtaining an information block of length K based on the third bit sequence,
      wherein the third bit sequence is provided based on polar encoding for a second bit sequence $\mathbf{u}^{2N} = \{u_0,...,u_{2N-1}\}$,
      wherein the second bit sequence is provided via convolution precoding for a first bit sequence $\mathbf{v}^{2N} = \{v_0,...,v_{2N-1}\}$,
      wherein the first bit sequence $\mathbf{v}^{2N}$ is provided based on the information block of length K and a polar sequence $\mathbf{Q}^{2N-1}_0 = \{Q_0, Q_1, ..., Q_{2N-1}\}$ of length 2N,
      wherein the polar sequence $\mathbf{Q}^{2N-1}_0 = \{Q_0, Q_1, ..., Q_{2N-1}\}$ of length 2N is defined in ascending order of reliability $W(Q^{2N}_0) < W(Q^{2N}_1) < ... < W(Q^{2N}_{2N-1})$, where $0 <= Q^{2N}_i <= 2N-1$ is a bit index for $i = 0, 1, ..., 2N-1$, and $W(Q^{2N}_i)$ is reliability of bit index $Q^{2N}_i$, and
      wherein, from among first N bit indices in the first bit sequence $\mathbf{v}^{2N}$, last m bit indices include predetermined bit values, and from among remaining (2N-m) bit indices, K bit indices include K bit values of the information block, where m is a number of shift registers for the convolution precoding.

17. A computer-readable storage medium storing at least one computer program code including instructions that, when executed, cause at least one processor to perform operations, the operations comprising:

   receiving a third bit sequence including coded bits; and
   obtaining an information block of length K based on the third bit sequence,
   wherein the third bit sequence is provided based on polar encoding for a second bit sequence $\mathbf{u}^{2N} = \{u_0,...,u_{2N-1}\}$,
   wherein the second bit sequence is provided via convolution precoding for a first bit sequence $\mathbf{v}^{2N} = \{v_0,...,v_{2N-1}\}$,
   wherein the first bit sequence $\mathbf{v}^{2N}$ is provided based on the information block of length K and a polar sequence $\mathbf{Q}^{2N-1}_0 = \{Q_0, Q_1, ..., Q_{2N-1}\}$ of length 2N,
   wherein the polar sequence $Q^{2N-1}_0 = \{Q_0, Q_1, ..., Q_{2N-1}\}$ of length 2N is defined in ascending order of reliability $W(Q^{2N}_0) < W(Q^{2N}_1) < ... < W(Q^{2N}_{2N-1})$, where $0 <= Q^{2N}_i <= 2N-1$ is a bit index for $i = 0, 1, ..., 2N-1$, and $W(Q^{2N}_i)$ is reliability of bit index $Q^{2N}_i$, and
   wherein, from among first N bit indices in the first bit sequence v2N, last m bit indices include predetermined bit values, and from among remaining (2N-m) bit indices, K bit indices include K bit values of the information block, where m is a number of shift registers for the convolution precoding.

**FIG. 1**

1

## FIG. 2

## FIG. 3

# FIG. 4

| One Frame (10 ms) |
|---|

| Half-Frame (5ms) | Half-Frame (5ms) |
|---|---|

| Subframe 0 (1ms) | ... | Subframe 4 (1ms) | Subframe 5 (1ms) | ... | Subframe 9 (1ms) |
|---|---|---|---|---|---|

Subframe (1ms)

**15kHz**

| Slot (14 symbols) |
|---|

1ms

**30kHz**

| Slot 0 (14 symbols) | Slot 1 |
|---|---|

500us

**60kHz**

| Slot 0 (14 Slot) | Slot 1 | Slot 2 | Slot 3 |
|---|---|---|---|

250us

**120kHz**

| Slot 0 (14 symbols) | Slot 1 | Slot 2 | Slot 3 | Slot 4 | Slot 5 | Slot 6 | Slot 7 |
|---|---|---|---|---|---|---|---|

125us

# FIG. 5

Transport Block (TB)

○

↓

TB CRC attachment

↓

Code Block (CB) segmentation

↓

CB CRC attachment

↓

Channel Coding

↓

Rate matching

↓

CBs Concatenation

↓

○

# FIG. 6

$$F = \begin{bmatrix} 1 & 0 \\ 1 & 1 \end{bmatrix}$$

(a)                                                                         (b)

# FIG. 7

Original channels
(uniform)

New channels
(polarized)

Vector channel

W

W₁

⋮

W_vec

⋮

W

W_N-1

W

W_N

Combine

Split

(a)

U₁  G_N  X₁  W  Y₁

U₂  X₂  W  Y₂

⋮  ⋮  ⋮  ⋮

U_N  X_N  W  Y_N

W_vec

(b)

# FIG. 8

**FIG. 9**

# FIG. 10

$C(W_i)$    Rank

| $C(W_i)$ | Rank | | | |
|---|---|---|---|---|
| 0.0039 | 8 | frozen | $u_1$ | $x_1 = \sum_{i=1}^{8} u_i$ |
| 0.1211 | 7 | frozen | $u_2$ | $x_2 = u_2 \oplus u_4 \oplus u_6 \oplus u_8$ |
| 0.1914 | 6 | frozen | $u_3$ | $x_3 = u_3 \oplus u_4 \oplus u_7 \oplus u_8$ |
| 0.6836 | 5 | data | $u_4$ | $x_4 = u_4 \oplus u_8$ |
| 0.3164 | 4 | frozen | $u_5$ | $x_5 = u_5 \oplus u_6 \oplus u_7 \oplus u_8$ |
| 0.8086 | 3 | data | $u_6$ | $x_6 = u_6 \oplus u_8$ |
| 0.8789 | 2 | data | $u_7$ | $x_7 = u_7 \oplus u_8$ |
| 0.9961 | 1 | data | $u_8$ | $x_8 = u_8$ |

$x_1$ W $y_1$
$x_2$ W $y_2$
$x_3$ W $y_3$
$x_4$ W $y_4$
$x_5$ W $y_5$
$x_6$ W $y_6$
$x_7$ W $y_7$
$x_8$ W $y_8$

# FIG. 11

# FIG. 12

Left cyclic shift upon encoding each bit

# FIG. 13

$c_0, c_1, c_2, c_3, ..., c_{K-1}$

Channel encoder

Coded bits $d_0, d_1, d_2, d_3, ..., d_{N-1}$

Sub-block

| Sub-block interleaver | Sub-block interleaver | ... | Sub-block interleaver | Sub-block interleaver |

Interleaved coded bits $y_0, y_1, y_2, y_3, ..., y_{N-1}$

Circular buffer

RV1  RV2

RV0  RV3

# FIG. 14

Irregular tree code

d → Rate profiling → v → Convolution → u

Polarized channel

Polar transform → x → Channel → y

Tree search algorithm

d̂ ← Data extraction ← v̂ ← Sequential decoder ← m ← Metric calculator

Metric requests

# FIG. 15

# FIG. 16

Previous transmission (N=8, K=6)

reliability order | 0 | 1 | 2 | 4 | 3 | 5 | 6 | 7

bit index information

| 0 | 1 | 2 | 3 | 4 | 5 | 6 | 7 |
| | | $c_0$ | $c_1$ | $c_2$ | $c_3$ | $c_4$ | $c_5$ |

(a)

Current transmission (N=16, K=6)

reliability order | 0 | 1 | 2 | 5 | 3 | 6 | 8 | 11 | 4 | 7 | 9 | 12 | 10 | 13 | 14 | 15

bit index information

| 0 | 1 | 2 | 3 | 4 | 5 | 6 | 7 | 8 | 9 | 10 | 11 | 12 | 13 | 14 | 15 |
| | | | | | | | $c_0$ | | | $c_0$ | $c_1$ | $c_2$ | $c_3$ | $c_4$ | $c_5$ |

copy

(b)

copy

◯ : bit index with information bit          ⟨ ⟩ : bit index which is frozen

FIG. 17

(a) 1st transmission, K=20, N=32

(b) 2nd transmission, K=20, N=64

# FIG. 18

Polar sequence $Q_0^{N-1}$ for N=32

Bit index 0 to N-1 for N=32

Information bits $u_0$ to $u_{K-1}$ allocated

(a) 1st transmission, K=20, N=32

Polar sequence $Q_0^{N-1}$ for N=64

Bit index 0 to N-1 for N=64

Bit indexes with information/frozen bits

(b) 2nd transmission, K=20, N=64

■ most reliable bit index(es)    ⬚ bit index with copy operation

EP 4 583 412 A1

## FIG. 19

convolution

Shift register

$v_n$

$c_1$

1

$u_n$

## FIG. 20

convolution

Shift register

v

$c_1$ $c_2$ ... $c_m$

1 2 ... m

u

# FIG. 21

Polar sequence $Q^{N-1}_0$ for N=32

| 0 | 1 | 2 | 4 | 8 | 16 | 3 | 5 | 6 | 17 | 10 | 18 | 12 | 20 | 24 | 7 | 11 | 19 | 13 | 14 | 21 | 26 | 25 | 22 | 28 | 15 | 23 | 27 | 29 | 30 | 31 |

Bit index 0 to N-1 for N=32

| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 |

Information bits $u_0$ to $u_{K-1}$ allocated

(a) 1st transmission, K=20, N=32

Polar sequence $Q^{N-1}_0$ for N=64

| 0 | 1 | 2 | 4 | 8 | 16 | 32 | 3 | 5 | 9 | 6 | 17 | 10 | 18 | 12 | 33 | 20 | 34 | 24 | 36 | 7 | 11 | 40 | 19 | 13 | 48 | 14 | 21 | 35 | 26 | 37 | 25 | 22 | 38 | 41 | 28 | 42 | 49 | 44 | 50 | 15 | 52 | 23 | 56 | 27 | 39 | 29 | 43 | 30 | 45 | 51 | 46 | 53 | 54 | 57 | 58 | 60 | 31 | 47 | 55 | 59 | 61 | 62 | 63 |

Bit index 0 to N-1 for N=64

| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 | 52 | 53 | 54 | 55 | 56 | 57 | 58 | 59 | 60 | 61 | 62 | 63 |

Bit indexes with information/frozen bits

(b) 2nd transmission, K=20, N=64

■ most reliable bit index(es)    ⬚ bit index with copy operation    ▨ next reliable bit index(es) for information

▧ bit index with information related to recursive convolution

# FIG. 22

Determine first bit sequence v, which is input to convolution precoding, based on information block having length K and polar sequence $Q^{N-1}_0$ having length N — S2201

Determine second bit sequence u based on convolution precoding for first bit sequence v — S2203

Polar encoding for second bit sequence u — S2205

# FIG. 23

Receive third bit sequence — S2301

Determine information block having length K based on polar decoding for third bit sequence — S2303

## INTERNATIONAL SEARCH REPORT

| International application No. |
|---|
| **PCT/KR2023/013047** |

### A. CLASSIFICATION OF SUBJECT MATTER

**H03M 13/29**(2006.01)i; **H03M 13/13**(2006.01)i; **H03M 13/23**(2006.01)i; **H03M 13/00**(2006.01)i; **H04L 1/00**(2006.01)i; **H04L 1/18**(2006.01)i

According to International Patent Classification (IPC) or to both national classification and IPC

### B. FIELDS SEARCHED

Minimum documentation searched (classification system followed by classification symbols)

H03M 13/29(2006.01); H03M 13/00(2006.01); H03M 13/13(2006.01); H03M 13/23(2006.01); H03M 13/39(2006.01); H03M 13/45(2006.01); H04L 1/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 폴라(polar), 시퀀스(sequence), 컨볼루션(convolution), 프리코딩 (precoding), 비트 인덱스(bit index), 천이 레지스터(transfer register), 신뢰도(reliability)

### C. DOCUMENTS CONSIDERED TO BE RELEVANT

| Category* | Citation of document, with indication, where appropriate, of the relevant passages | Relevant to claim No. |
|---|---|---|
| A | US 2021-0273659 A1 (THE REGENTS OF THE UNIVERSITY OF CALIFORNIA) 02 September 2021 (2021-09-02)<br>See paragraphs [0004]-[0006]; and claims 1-9. | 1-16 |
| A | KR 10-2019-0126806 A (ZTE CORPORATION) 12 November 2019 (2019-11-12)<br>See paragraphs [0006]-[0025]; and claims 1-12. | 1-16 |
| A | WO 2021-188513 A1 (THE REGENTS OF THE UNIVERSITY OF CALIFORNIA) 23 September 2021 (2021-09-23)<br>See paragraphs [0004]-[0006]; and claims 1-10. | 1-16 |
| A | US 2020-0177211 A1 (THE REGENTS OF THE UNIVERSITY OF CALIFORNIA) 04 June 2020 (2020-06-04)<br>See paragraphs [0004]-[0007]; and claims 1-18. | 1-16 |

☑ Further documents are listed in the continuation of Box C. ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **07 December 2023** | **07 December 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2023/013047**

**C.     DOCUMENTS CONSIDERED TO BE RELEVANT**

| Category* | Citation of document, with indication, where appropriate, of the relevant passages | Relevant to claim No. |
|---|---|---|
| A | KR 10-2019-0116816 A (SAMSUNG ELECTRONICS CO., LTD.) 15 October 2019 (2019-10-15) See paragraphs [0009]-[0014]; and claim 1. | 1-16 |

Form PCT/ISA/210 (second sheet) (July 2022)

## INTERNATIONAL SEARCH REPORT
### Information on patent family members

International application No.

**PCT/KR2023/013047**

| Patent document cited in search report | | | Publication date (day/month/year) | Patent family member(s) | | | Publication date (day/month/year) |
|---|---|---|---|---|---|---|---|
| US | 2021-0273659 | A1 | 02 September 2021 | CN | 114073024 | A | 18 February 2022 |
| | | | | EP | 3977653 | A1 | 06 April 2022 |
| | | | | US | 11012100 | B2 | 18 May 2021 |
| | | | | US | 11398842 | B2 | 26 July 2022 |
| | | | | US | 2020-0382138 | A1 | 03 December 2020 |
| | | | | WO | 2020-247508 | A1 | 10 December 2020 |
| KR | 10-2019-0126806 | A | 12 November 2019 | CN | 108429603 | A | 21 August 2018 |
| | | | | CN | 114598424 | A | 07 June 2022 |
| | | | | EP | 3584970 | A1 | 25 December 2019 |
| | | | | JP | 2020-511051 | A | 09 April 2020 |
| | | | | JP | 2022-009388 | A | 14 January 2022 |
| | | | | JP | 7030131 | B2 | 04 March 2022 |
| | | | | JP | 7248762 | B2 | 29 March 2023 |
| | | | | KR | 10-2021-0102484 | A | 19 August 2021 |
| | | | | KR | 10-2419967 | B1 | 11 July 2022 |
| | | | | US | 11121724 | B2 | 14 September 2021 |
| | | | | US | 11496156 | B2 | 08 November 2022 |
| | | | | US | 11683052 | B2 | 20 June 2023 |
| | | | | US | 2019-0372599 | A1 | 05 December 2019 |
| | | | | US | 2021-0409039 | A1 | 30 December 2021 |
| | | | | US | 2022-0140844 | A1 | 05 May 2022 |
| | | | | WO | 2018-149411 | A1 | 23 August 2018 |
| WO | 2021-188513 | A1 | 23 September 2021 | CN | 115398809 | A | 25 November 2022 |
| | | | | EP | 4122102 | A1 | 25 January 2023 |
| | | | | JP | 2023-519190 | A | 10 May 2023 |
| | | | | KR | 10-2023-0003466 | A | 06 January 2023 |
| | | | | US | 2023-0179229 | A1 | 08 June 2023 |
| US | 2020-0177211 | A1 | 04 June 2020 | US | 11121728 | B2 | 14 September 2021 |
| | | | | US | 11489546 | B2 | 01 November 2022 |
| | | | | US | 2021-0367620 | A1 | 25 November 2021 |
| KR | 10-2019-0116816 | A | 15 October 2019 | CN | 111954982 | A | 17 November 2020 |
| | | | | EP | 3747129 | A1 | 09 December 2020 |
| | | | | US | 11012185 | B2 | 18 May 2021 |
| | | | | US | 11546087 | B2 | 03 January 2023 |
| | | | | US | 2019-0312676 | A1 | 10 October 2019 |
| | | | | US | 2021-0273746 | A1 | 02 September 2021 |
| | | | | US | 2023-0139488 | A1 | 04 May 2023 |
| | | | | WO | 2019-194635 | A1 | 10 October 2019 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **E. ARIKAN**. Channel Polarization: A Method for Constructing Capacity-Achieving Codes for Symmetric Binary-Input Memoryless Channels. *IEEE Transactions on Information Theory*, July 2009, vol. 55 (7), 3051-3073

- **I. TAL** ; **A. VARDY**. List decoding of polar codes. *Proc. IEEE Int. Symp. Inf. Theory*, July 2011, 1-5
- **M. ROWSHAN** ; **A. BURG** ; **E. VITERBO**. Polarization-adjusted convolutional (PAC) codes: sequential decoding vs list decoding. *IEEE Tr. VT.*, 2021, vol. 70 (2)